# EUROPEAN PATENT APPLICATION

(11) **EP 4 709 075 A1**
(43) Date of publication of application: **11.03.2026**
(21) Application number: 25196073.8
(22) Date of filing: 14.08.2025
(51) Int. Cl.: H10B 12/00

(54) **SEMICONDUCTOR MEMORY DEVICE**

(30) Priority: 09.09.2024 KR 20240122381
(71) Applicant: Samsung Electronics Co., Ltd., Suwon-si, Gyeonggi-do 16677 (KR)
(72) Inventor: JANG, Sung-Hwan, 16677 Suwon-si (KR); KIM, Bit Na, 16677 Suwon-si (KR)
(74) Representative: Marks & Clerk LLP

(57) **Abstract**

A semiconductor memory device includes a bitline that extends in a first direction on a substrate, a first active pattern and a second active pattern that are on the bitline and spaced apart from each other in the first direction, at least one conductive gate line that is between the first active pattern and the second active pattern and extends in a second direction, a gate shielding pattern that is between the at least one conductive gate line and the bitline and includes an insulating material that is doped with phosphorus (P), and a data storage pattern that is on and electrically connected to the first active pattern and the second active pattern.

## Description

### TECHNICAL FIELD

The present disclosure relates to a semiconductor memory device and, more particularly, to a semiconductor memory device including vertical channel transistors (VCTs).

### BACKGROUND

To meet consumer demands for excellent performance and low cost, increasing the integration density of semiconductor memory devices may be desirable. Since the integration density of semiconductor memory devices is a factor in determining the product price, particularly higher integration density may be desired.

The integration density of two-dimensional (2D) or planar semiconductor memory devices may be determined by the area occupied by unit memory cells and is thus influenced by the level of fine patterning technology. However, since ultra-high-cost equipment is utilized for miniaturizing patterns, the integration density of 2D semiconductor memory devices, although increasing, remains limited. Accordingly, semiconductor memory devices including vertical channel transistors (VCTs), where the channels extend vertically, have been proposed.

### SUMMARY

Aspects of the present disclosure provide a semiconductor memory device with improved integration density and electrical characteristics.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to an aspect of the present disclosure, there is provided a semiconductor memory device comprising a bitline that extends in a first direction on a substrate, a first active pattern and a second active pattern that are on the bitline and spaced apart from each other in the first direction, at least one conductive gate line that is between the first active pattern and the second active pattern and extends in a second direction, a gate shielding pattern that is between the at least one conductive gate line and the bitline and includes an insulating material that is doped with phosphorus (P), and a data storage pattern that is on and electrically connected to the first active pattern and the second active pattern.

According to another aspect of the present disclosure, there is provided a semiconductor memory device comprising a bitline that extends in a first direction on a substrate, an active pattern disposed on the bitline, the active pattern including a first sidewall and a second sidewall opposite to each other in the first direction, the active pattern including a first surface and a second surface opposite to each other in a vertical direction that is perpendicular to the substrate, wherein the first surface of the active pattern is electrically connected to the bitline, a wordline that is on the first sidewall of the active pattern and extends in a second direction, a back gate electrode that is on the second sidewall of the active pattern and extends in the second direction, a first gate shielding pattern between the wordline and the bitline, a second gate shielding pattern between the back gate electrode and the bitline, and a data storage pattern that is on the active pattern and electrically connected to the second surface of the active pattern, where at least one of the first gate shielding pattern and the second gate shielding pattern includes phosphorus silicate glass (PSG).

According to another aspect of the present disclosure, there is provided a semiconductor memory device comprising a peri-gate structure on a substrate, a first bonding pad on the peri-gate structure, a second bonding pad that is on and contacts the first bonding pad, a bitline that is on the second bonding pad and extends in a first direction, a shielding conductive pattern that is on the second bonding pad, is adjacent to the bitline, extends in the first direction, and includes a plurality of shielding conductive line patterns, a first wordline that is on the bitline and the shielding conductive pattern and extends in a second direction, a second wordline that is on the bitline and the shielding conductive pattern, extends in the second direction, and is spaced apart from the first wordline in the first direction, a back gate electrode that is between the first wordline and the second wordline and extends in the second direction, a first active pattern that is on the bitline and is between the first wordline and the back gate electrode, a second active pattern that is on the bitline and is between the second wordline and the back gate electrode, a first gate shielding pattern that is between the first wordline and the bitline, is between the second wordline and the bitline, and includes an insulating material that is doped with phosphorus (P), and a data storage pattern electrically connected to the first active pattern and the second active pattern.

It should be noted that the effects of the present disclosure are not limited to those described above, and other effects of the present disclosure will be apparent from the following description.

At least some of the above and other features of the invention are set out in the claims.

### BRIEF DESCRIPTION OF THE DRAWINGS

The above and other aspects and features of the present disclosure will become more apparent by describing in detail example embodiments thereof with reference to the attached drawings, in which:
FIG. 1 is a layout diagram for explaining a semiconductor memory device according to some embodiments.
FIG. 2 is a cross-sectional view taken along lines A - A and B - B of FIG. 1.
FIG. 3 is a cross-sectional view taken along lines C - C and D - D of FIG. 1.
FIG. 4 is an enlarged cross-sectional view of part P of FIG. 2.
FIG. 5 is an example diagram for explaining the concentration of phosphorus (P) in gate shielding patterns and first impurity doping regions of FIG. 4.
FIG. 6 is a diagram for explaining a semiconductor memory device according to some embodiments.
FIGS. 7 through 9 are diagrams for explaining a semiconductor memory device according to some embodiments.
FIGS. 10 and 11 are diagrams for explaining a semiconductor memory device according to some embodiments.
FIG. 12 is a diagram for explaining a semiconductor memory device according to some embodiments.
FIGS. 13 and 14 are diagrams for explaining a semiconductor memory device according to some embodiments.
FIGS. 15 and 16 are diagrams for explaining a semiconductor memory device according to some embodiments.
FIGS. 17 and 18 are diagrams for explaining a semiconductor memory device according to some embodiments.
FIGS. 19 and 20 are diagrams for explaining a semiconductor memory device according to some embodiments.
FIGS. 21 through 24 are diagrams for explaining semiconductor memory devices according to some embodiments.
FIGS. 25 through 55 are diagrams for explaining intermediate steps of a method for manufacturing a semiconductor memory device according to some embodiments.

### DETAILED DESCRIPTION

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device. Components or layers described with reference to "overlap" in a particular direction may be at least partially obstructed by one another when viewed along a line extending in the particular direction or in a plane perpendicular to the particular direction.

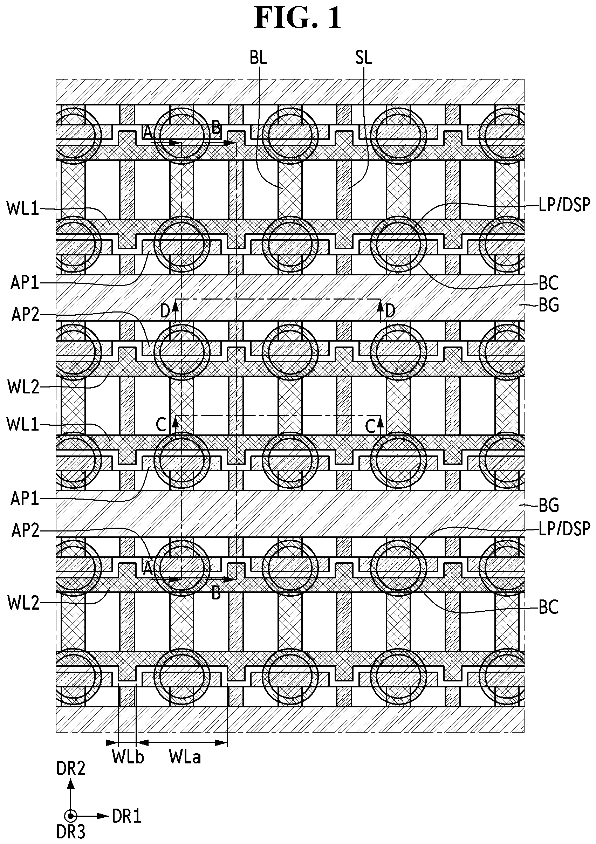

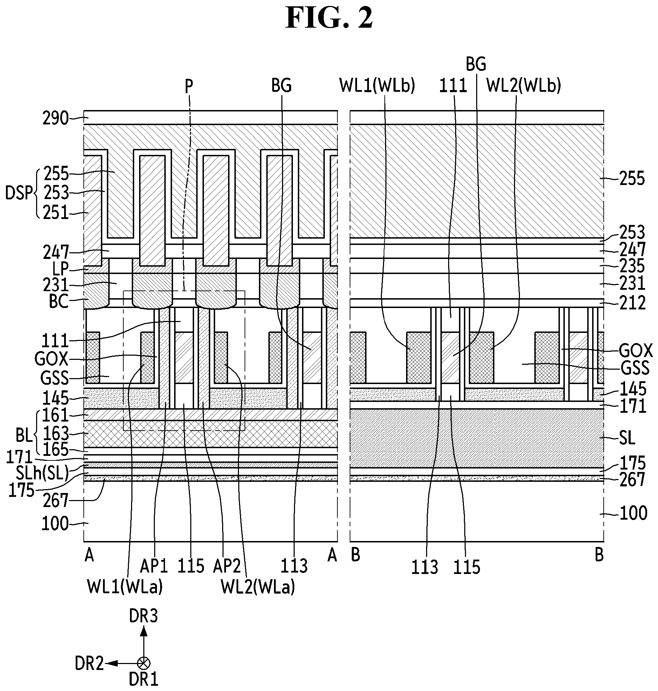

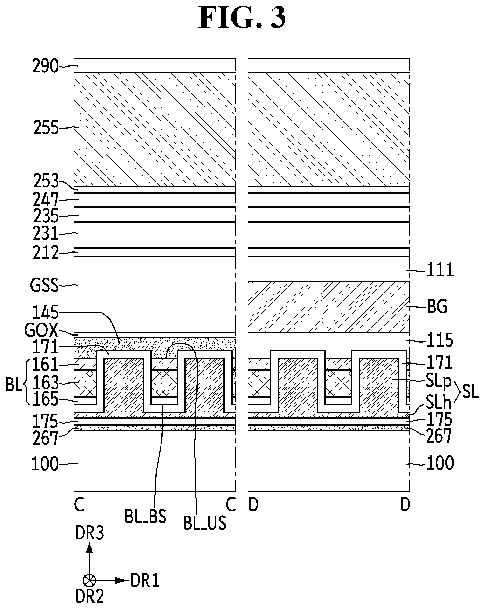

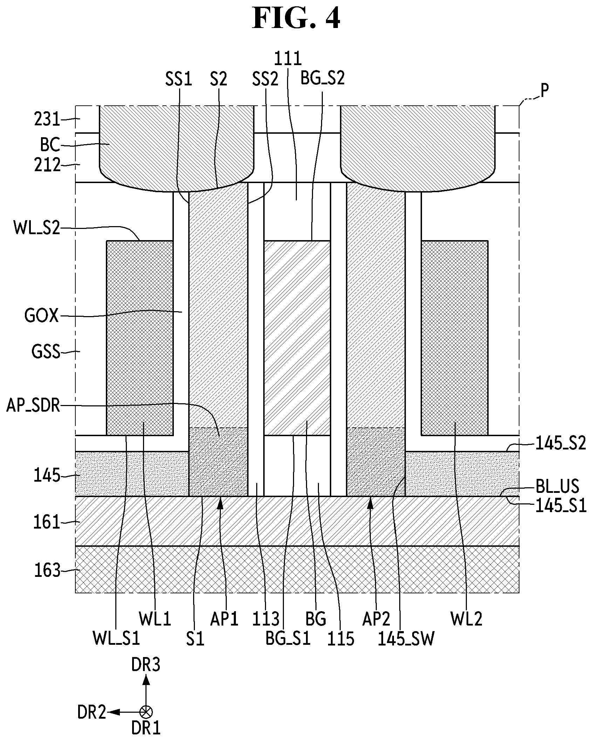

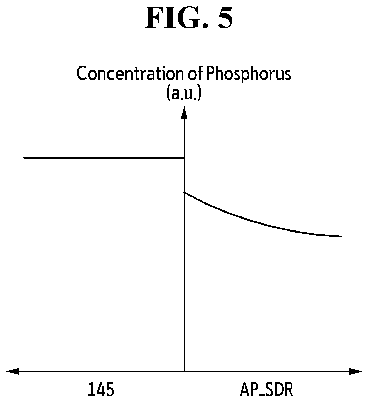

FIG. 1 is a layout diagram for explaining a semiconductor memory device according to some embodiments. FIG. 2 is a cross-sectional view taken along lines A - A and B - B of FIG. 1. FIG. 3 is a cross-sectional view taken along lines C - C and D - D of FIG. 1. FIG. 4 is an enlarged cross-sectional view of part P of FIG. 2. FIG. 5 is an example diagram for explaining the concentration of phosphorus (P) in gate shielding patterns and first impurity doping regions of FIG. 4.

The semiconductor memory device according to some embodiments may include memory cells that include vertical channel transistors (VCTs).

Referring to FIGS. 1 through 5, the semiconductor memory device according to some embodiments may include bitlines BL, first wordlines WL1, second wordlines WL2, back gate electrodes BG, shielding conductive patterns SL, first active patterns AP1, second active patterns AP2, and data storage patterns DSP.

A substrate 100 may be a silicon (Si) substrate, or may include other materials, such as silicon-germanium (SiGe), indium antimonide, a lead telluride compound, indium arsenide, indium phosphide, gallium arsenide, or gallium antimonide, but the present disclosure is not limited thereto.

Although not illustrated, the substrate 100 may include a cell array region where the data storage patterns DSP are disposed and a peripheral circuit region that is defined around the cell array region.

A bonding insulating film 267 may be disposed on the substrate 100. The bonding insulating film 267 may be used for bonding wafers. For example, the bonding insulating film 267 may include silicon carbonitride. In another example, the bonding insulating film 267 may include silicon oxide.

A shielding structure (171, SL, and 175) may be disposed on the substrate 100. For example, the shielding structure (171, SL, and 175) may be disposed on the bonding insulating film 267.

The shielding structure (171, SL, and 175) may include the shielding conductive patterns SL and shielding insulating films 171 and 175. For example, the shielding insulating films 171 and 175 may include a shielding insulating liner 171 and a shielding insulating capping film 175.

The shielding conductive patterns SL may include a shielding conductive plate SLh and a plurality of shielding conductive line patterns SLp. The shielding conductive plate SLh may have a flat plate shape.

Each of the shielding conductive line patterns SLp may extend in a second direction DR2. Each of the shielding conductive line patterns SLp may be adjacent to each other in a first direction DR1. Each of the shielding conductive line patterns SLp may protrude or extend from the shielding conductive plate SLh in a third direction DR3. Each of the shielding conductive line patterns SLp are directly connected to the shielding conductive plate SLh.

For example, the first and second directions DR1 and DR2 may be horizontal directions parallel to the substrate 100. The third direction DR3 may be a vertical direction perpendicular to the substrate 100.

The shielding conductive plate SLh and the shielding conductive line patterns SLp may extend from the cell array region to the peripheral circuit region. Parts of the shielding conductive patterns SL may be disposed on the peripheral circuit region, but the present disclosure is not limited thereto.

The shielding conductive patterns SL include a conductive material. For example, the shielding conductive patterns SL may include at least one of a conductive metal nitride, a conductive metal silicon nitride, a metal carbonitride, a conductive metal silicide, a conductive metal oxide, a 2D material, or a metal.

The shielding insulating capping film 175 may be disposed on the substrate 100. For example, the shielding insulating capping film 175 may be disposed between the substrate 100 and the shielding conductive patterns SL.

The shielding insulating capping film 175 may contact the shielding conductive patterns SL. In some embodiments, the shielding insulating capping film 175 may contact the shielding conductive plate SLh.

The shielding insulating liner 171 may be disposed on the shielding conductive patterns SL. The shielding insulating liner 171 may be disposed between the bitlines BL and the substrate 100. The shielding insulating liner 171 may extend along the profile of the shielding conductive plate SLh and the shielding conductive line patterns SLp.

The shielding insulating liner 171 and the shielding insulating capping film 175 may be formed of an insulating material. If the shielding insulating liner 171 and the shielding insulating capping film 175 are formed of the same material, the boundary between the shielding insulating liner 171 and the shielding insulating capping film 175 may not be distinguishable.

As the shielding structure (171, SL, and 175) is disposed between adjacent bitlines BL in the first direction DR1, thereby reducing or inhibiting coupling noise between the bitlines BL.

The bitlines BL may be disposed on the substrate 100. For example, the bitlines BL may be disposed on the bonding insulating film 267.

The bitlines BL may extend in the second direction DR2. Adjacent bitlines BL may be spaced apart in the first direction DR1. The bitlines BL include long sidewalls extending in the second direction DR2 and short sidewalls extending in the first direction DR1.

The bitlines BL may be disposed on the shielding conductive patterns SL. The bitlines BL may be disposed on the shielding conductive plate SLh.

The bitlines BL may be disposed adjacent to the shielding conductive line patterns SLp in the first direction DR1. That is, the shielding conductive line patterns SLp may extend in the second direction DR2 along the long sidewalls of the bitlines BL.

The bitlines BL may be disposed between adjacent shielding conductive line patterns SLp in the first direction DR1. The bitlines BL may be disposed on the shielding insulating liner 171. For example, the shielding insulating liner 171 may contact the bitlines BL.

Although not illustrated, the bitlines BL may extend from the cell array region to the peripheral circuit region. Parts of the bitlines BL may be disposed on the peripheral circuit region.

The bitlines BL may include upper surfaces BL_US and bottom surfaces BL_BS that are opposite to each other in the third direction DR3. The upper surfaces BL_US of the bitlines BL may face the first active patterns AP1 and the second active patterns AP2, which will be described later.

In some embodiments, the shielding conductive patterns SL may be disposed on the bottom surfaces BL_BS of the bitlines BL. For example, the shielding conductive plate SLh may be disposed on the bottom surfaces BL_BS of the bitlines BL.

The bitlines BL may include semiconductor patterns 161, metal patterns 163, and bitline mask patterns 165 that are sequentially stacked. Alternatively, contrary to what is illustrated, the bitlines BL may include the semiconductor patterns 161 or the metal patterns 163. Yet alternatively, each of the bitlines BL may not include the bitline mask patterns 165.

The bitlines BL may include conductive bitlines. The conductive bitlines include films formed of a conductive material. The conductive bitlines may include the semiconductor patterns 161 and the metal patterns 163.

The semiconductor patterns 161 may include a conductive semiconductor material. The conductive semiconductor material may be, for example, a semiconductor material doped with impurities. The semiconductor patterns 161 may include at least one of polysilicon, poly-SiGe, poly-germanium (Ge), amorphous Si, amorphous SiGe, or amorphous Ge.

The metal patterns 163 may include a conductive material containing a metal. For example, the metal patterns 163 may include at least one of a conductive metal nitride, a conductive metal silicon nitride, a metal carbonitride, a conductive metal silicide, a conductive metal oxide, a 2D material, or a metal. In some embodiments, the 2D material may be a metallic material and/or a semiconductor material. The 2D material may include a 2D allotrope or a 2D compound. For example, the 2D material may include at least one of graphene, molybdenum disulfide (MoS₂), molybdenum diselenide (MoSe₂), tungsten diselenide (WSe₂), or tungsten disulfide (WS2), but the present disclosure is not limited thereto. In other words, the aforementioned 2D materials are merely examples, and the present disclosure is not limited thereto.

The bitline mask patterns 165 may include an insulating material. The bitline mask patterns 165 may include, for example, silicon nitride or silicon oxynitride, but the present disclosure is not limited thereto.

The first active patterns AP1 and the second active patterns AP2 may be disposed on the bitlines BL. The first active patterns AP1 and the second active patterns AP2 may be alternately arranged along the second direction DR2.

The first active patterns AP1 may be spaced apart from each other in the first direction DR1. The first active patterns AP1 may be spaced apart at regular intervals. The second active patterns AP2 may be spaced apart from each other in the first direction DR1. The second active patterns AP2 may be spaced apart at regular intervals. The first active patterns AP1 may be spaced apart from the second active patterns AP2 in the second direction DR2. The first active patterns AP1 and the second active patterns AP2 may be two-dimensionally arranged along the first and second directions DR1 and DR2 that intersect each other.

For example, the first active patterns AP1 and the second active patterns AP2 may be formed of a monocrystalline semiconductor material. In one example, the first active patterns AP1 and the second active patterns AP2 may be formed of monocrystalline Si. The first active patterns AP1 and the second active patterns AP2 may be Si active patterns.

The first active patterns AP1 and the second active patterns AP2 may have a length in the first direction DR1, a width in the second direction DR2, and a height in the third direction DR3. The first active patterns AP1 and the second active patterns AP2 may have a substantially uniform width. That is, the first active patterns AP1 and the second active patterns AP2 may have substantially the same width at their first surfaces S1 and second surfaces S2. In addition, the width of the first active patterns AP1 may be the same as the width of the second active patterns AP2.

The widths of the first active patterns AP1 and the second active patterns AP2 may range from several nanometers to several tens of nanometers. For example, the widths of the first active patterns AP1 and the second active patterns AP2 may range from 1 nm to 30 nm, such as about from 1 nm to 10 nm, but the present disclosure is not limited thereto. The length of the first active patterns AP1 and the second active patterns AP2 may be greater than the linewidth of the bitlines BL. That is, the length of the first active patterns AP1 and the second active patterns AP2 may be greater than the width, in the first direction DR1, of the bitlines BL.

In FIG. 4, the first active patterns AP1 and the second active patterns AP2 include first surfaces S1 and second surfaces S2 that are opposite to each other in the third direction DR3. For example, the first surfaces S1 of the first active patterns AP1 and second active patterns AP2 may face the bitlines BL. The second surfaces S2 of the first active patterns AP1 and the second surfaces S2 of the second active patterns AP2 may face contact patterns BC.

The first surfaces S1 of the first active patterns AP1 and the first surfaces S1 of the second active patterns AP2 are connected to the bitlines BL. For example, the first surfaces S1 of the first active patterns AP1 and the first surfaces S1 of the second active patterns AP2 may be connected to the semiconductor patterns 161 of the bitlines BL. Contrary to what is illustrated, in a case where the semiconductor patterns 161 are omitted, the first surfaces S1 of the first active patterns AP1 and the first surfaces S1 of the second active patterns AP2 may be connected to the metal patterns 163. The second surfaces S2 of the first active patterns AP1 and the second surfaces S2 of the second active patterns AP2 may be connected to the contact patterns BC.

The first active patterns AP1 and the second active patterns AP2 may include first sidewalls SS1 and second sidewalls SS2 that are opposite to each other in the second direction DR2. The second sidewalls SS2 of the first active patterns AP1 may face the first sidewalls SS1 of the second active patterns AP2.

The first sidewalls SS1 of the first active patterns AP1 may be adjacent to the first wordlines WL1. The second sidewalls SS2 of the second active patterns AP2 may be adjacent to the second wordlines WL2.

For example, the first active patterns AP1 and the second active patterns AP2 may include first impurity doping regions AP_SDR. The first impurity doping regions AP_SDR may be adjacent to the bitlines BL. The first impurity doping regions AP_SDR may include a first impurity element that is doped. The first impurity element doped in the first impurity doping regions AP_SDR may be an n-type impurity element. The first impurity element may include phosphorus (P). The first impurity element doped in the first impurity doping regions AP_SDR may be the same as a second impurity element doped in gate shielding patterns 145, which will be described later.

Although not illustrated, in one example, the first active patterns AP1 and the second active patterns AP2 may include second impurity doping regions adjacent to the respective contact patterns BC. The first active patterns AP1 and the second active patterns AP2 may include channel regions between the first impurity doping regions AP_SDR and the second impurity doping regions.

During the operation of the semiconductor memory device, the channel regions of the first active patterns AP1 and second active patterns AP2 may be controlled by the first wordlines WL1, the second wordlines WL2, and the back gate electrodes BG. Since the first active patterns AP1 and the second active patterns AP2 are formed of a monocrystalline semiconductor material, the leakage current characteristics of the semiconductor memory device according to some embodiments can be improved.

The back gate electrodes BG may be disposed on the bitlines BL and the shielding conductive patterns SL. The back gate electrodes BG may be spaced apart from each other in the second direction DR2. The back gate electrodes BG may be spaced apart at regular intervals. Each of the back gate electrodes BG may extend in the first direction DR1 across the bitlines BL.

Each of the back gate electrodes BG may be disposed between pairs of adjacent first and second active patterns AP1 and AP2 in the second direction DR2. In other words, the first active patterns AP1 may be disposed on the first sides of each back gate electrode BG, and the second active patterns AP2 may be disposed on the second sides of each back gate electrode BG. The height, in the third direction DR3, of the back gate electrodes BG may be less than the height, in the third direction DR3, of the first active patterns AP1 and second active patterns AP2.

Each of the back gate electrodes BG may be disposed between the second sidewalls SS2 of the first active patterns AP1 and the first sidewalls SS1 of the second active patterns AP2. Each of the back gate electrodes BG may be disposed on the second sidewalls SS2 of the first active patterns AP1 and the first sidewalls SS1 of the second active patterns AP2.

The first active patterns AP1 may be disposed between the first wordlines WL1 and the back gate electrodes BG. The second active patterns AP2 may be disposed between the second wordlines WL2 and the back gate electrodes BG. Each pair of adjacent first and second wordlines WL1 and WL2 may be disposed between adjacent back gate electrodes BG in the second direction DR2.

The back gate electrodes BG may be first conductive gate lines disposed between the pairs of adjacent first and second active patterns AP1 and AP2. A single back gate electrode BG may be disposed between a pair of adjacent first and second active patterns AP1 and AP2.

The back gate electrodes BG may include first surfaces BG_S1 and second surfaces BG_S2 that are opposite to each other in the third direction DR3. The first surfaces BG_S1 of the back gate electrodes BG may be closer than the second surfaces BG_S2 of the back gate electrodes BG to the bitlines BL. The first surfaces BG_S1 of the back gate electrodes BG may face the bitlines BL.

The back gate electrodes BG may include a conductive material, for example, at least one of a conductive semiconductor material, a conductive metal nitride, a conductive metal silicon nitride, a metal carbonitride, a conductive metal silicide, a conductive metal oxide, a 2D material, or a metal.

During the operation of the semiconductor memory device according to some embodiments, a voltage may be applied to the back gate electrodes BG to adjust the threshold voltage of the VCTs. By adjusting the threshold voltage of the VCTs, degradation of leakage current characteristics can be prevented or inhibited.

Back gate separation patterns 111 may be disposed between the pairs of adjacent first and second active patterns AP1 and AP2 in the second direction DR2. The back gate separation patterns 111 may extend in the first direction DR1 parallel to the back gate electrodes BG. The back gate separation patterns 111 may be disposed on the second surfaces BG_S2 of the back gate electrodes BG.

The back gate separation patterns 111 may be formed of an insulating material. For example, the back gate separation patterns 111 may include silicon oxide, silicon oxynitride, or silicon nitride, but the present disclosure is not limited thereto.

The back gate insulating patterns 113 may be disposed between the back gate electrodes BG and the first active patterns AP1, and between the back gate electrodes BG and the second active patterns AP2. The back gate insulating patterns 113 may also be disposed between the back gate separation patterns 111 and the first active patterns AP1, and between the back gate separation patterns 111 and the second active patterns AP2.

The back gate insulating patterns 113 may be formed of an insulating material. For example, the back gate insulating patterns 113 may include silicon oxide, silicon oxynitride, a high-k dielectric material with a dielectric constant higher than silicon oxide, or combinations thereof.

The back gate shielding patterns 115 may be disposed between the bitlines BL and the back gate electrodes BG. The back gate shielding patterns 115 may be disposed between the pairs of adjacent first and second active patterns AP1 and AP2 in the second direction DR2. The back gate shielding patterns 115 may extend in the first direction DR1 parallel to the back gate electrodes BG. The back gate shielding patterns 115 may be disposed on the first surfaces BG_S1 of the back gate electrodes BG. The thickness of the back gate shielding patterns 115 between the bitlines BL may differ from the thickness of the back gate shielding patterns 115 on the upper surfaces BL_US of the bitlines BL, but the present disclosure is not limited thereto.

The back gate shielding patterns 115 may be formed of an insulating material. For example, the back gate shielding patterns 115 may include at least one of silicon oxide, silicon oxynitride, or silicon nitride, but the present disclosure is not limited thereto.

The first wordlines WL1 and the second wordlines WL2 may be disposed on the bitlines BL and the shielding conductive patterns SL. The first wordlines WL1 and the second wordlines WL2 may extend in the first direction DR1. The first wordlines WL1 and the second wordlines WL2 may be alternately arranged in the second direction DR2.

The first wordlines WL1 may be disposed closer than the second wordlines WL2 to the first active patterns AP1. The first wordlines WL1 may be disposed on the first sidewalls SS1 of the first active patterns AP1. The first wordlines WL1 may not be disposed on the second sidewalls SS2 of the first active patterns AP1.

The second wordlines WL2 may be disposed closer than the first wordlines WL1 to the second active patterns AP2. The second wordlines WL2 may be disposed on the second sidewalls SS2 of the second active patterns AP2. The second wordlines WL2 may not be disposed on the first sidewalls SS1 of the second active patterns AP2.

The first active patterns AP1 and the second active patterns AP2 may be disposed between pairs of adjacent first and second wordlines WL1 and WL2 in the second direction DR2. In other words, the first wordlines WL1 and the second wordlines WL2 may be disposed between the pairs of adjacent first and second active patterns AP1 and AP2 in the second direction DR2. The first wordlines WL1 and the second wordlines WL2 may be second conductive gate lines disposed between the pairs of adjacent first and second active patterns AP1 and AP2.

The first wordlines WL1 and the second wordlines WL2 may be spaced apart from the bitlines BL and the contact patterns BC in the third direction DR3. The first wordlines WL1 and the second wordlines WL2 may be positioned between the bitlines BL and the contact patterns BC.

The first wordlines WL1 and the second wordlines WL2 may have a width in the second direction DR2. For example, the widths of the first wordlines WL1 and the second wordlines WL2 on the bitlines BL may differ from the widths of the first wordlines WL1 and the second wordlines WL2 on shielding conductive lines SL.

For example, the first wordlines WL1 and the second wordlines WL2 may include first portions WLa and second portions WLb. The width, in the second direction DR2, of the first portions WLa may be smaller than the width, in the second direction DR2, of the second portions WLb. For example, the first portions WLa may be disposed on the bitlines BL, and the second portions WLb may be disposed on the shielding conductive patterns SL.

The first wordlines WL1 and the second wordlines WL2 may each include first portions WLa and second portions WLb that are alternately arranged along the first direction DR1. The first active patterns AP1 may be disposed between adjacent second portions WLb of the first wordlines WL1 in the first direction DR1. The second active patterns AP2 may be disposed between adjacent second portions WLb of the second wordlines WL2 in the first direction DR1.

Contrary to what is illustrated, the width, in the second direction DR2, of the first portions WLa of the first wordlines WL1 and second wordlines WL2 may be the same as the width, in the second direction DR2, of the second portions WLb of the first wordlines WL1 and second wordlines WL2. In other words, the widths of the first wordlines WL1 and the second wordlines WL2 on the bitlines BL may be the same as the widths of the first wordlines WL1 and the second wordlines WL2 on the shielding conductive lines SL. Gate insulating patterns GOX, which will be described later, may at least partially fill the spaces between adjacent first active patterns AP1 in the first direction DR1, and the spaces between adjacent second active patterns AP2 in the first direction DR1.

The first wordlines WL1 and the second wordlines WL2 may include first surfaces WL_S1 and second surfaces WL_S2 that are opposite to each other in the third direction DR3. The first surfaces WL_S1 of the first wordlines WL1 and second wordlines WL2 may be closer than the second surfaces WL_S2 of the first wordlines WL1 and second wordlines WL2 to the bitlines BL. The first surfaces WL_S1 of the first wordlines WL1 and second wordlines WL2 may face the bitlines BL.

For example, the height, in the third direction DR3, of the first wordlines WL1 may be the same as the height, in the third direction DR3, of the back gate electrodes BG. In another example, the height, in the third direction DR3, of the first wordlines WL1 may be greater than the height, in the third direction DR3, of the back gate electrodes BG. In yet another example, the height, in the third direction DR3, of the first wordlines WL1 may be smaller than the height, in the third direction DR3, of the back gate electrodes BG.

Additionally, for example, the height of the first surfaces WL_S1 of the first wordlines WL1 may be the same as the height of the first surfaces BG_S1 of the back gate electrodes BG relative to the upper surfaces BL_US of the bitlines BL in the third direction DR3. In another example, the first surfaces WL_S1 of the first wordlines WL1 may be higher than the first surfaces BG_S1 of the back gate electrodes BG relative to the upper surfaces BL_US of the bitlines BL in the third direction DR3. In yet another example, the first surfaces WL_S1 of the first wordlines WL1 may be lower than the first surfaces BG_S1 of the back gate electrodes BG relative to the upper surfaces BL_US of the bitlines BL in the third direction DR3.

Also, for example, the height of the second surfaces WL_S2 of the first wordlines WL1 may be the same as the height of the second surfaces BG_S2 of the back gate electrodes BG relative to the upper surfaces BL_US of the bitlines BL in the third direction DR3. In another example, the second surfaces WL_S2 of the first wordlines WL1 may be higher than the second surfaces BG_S2 of the back gate electrodes BG relative to the upper surfaces BL_US of the bitlines BL in the third direction DR3. In yet another example, the second surfaces WL_S2 of the first wordlines WL1 may be lower than the second surfaces BG_S2 of the back gate electrodes BG relative to the upper surfaces BL_US of the bitlines BL in the third direction DR3.

The first surfaces WL_S1 of the first wordlines WL1 and second wordlines WL2 may be planar or coplanar, but the present disclosure is not limited thereto. The second surfaces WL_S2 of the first wordlines WL1 and second wordlines WL2 may also be planar or coplanar, but the present disclosure is not limited thereto. The first surfaces BG_S1 and second surfaces BG_S2 of the back gate electrodes BG are illustrated as being planar or coplanar, but the present disclosure is not limited thereto.

The first wordlines WL1 and the second wordlines WL2 may include a conductive material. The first wordlines WL1 and the second wordlines WL2 may include, for example, at least one of a conductive semiconductor material, a conductive metal nitride, a conductive metal silicon nitride, a metal carbonitride, a conductive metal silicide, a 2D material, or a metal.

The gate insulating patterns GOX may be disposed between the first wordlines WL1 and the first active patterns AP1, and between the second wordlines WL2 and the second active patterns AP2. The gate insulating patterns GOX may extend in the first direction DR1 parallel to the first wordlines WL1 and the second wordlines WL2.

The gate insulating patterns GOX may include silicon oxide, silicon oxynitride, a high-k dielectric material with a dielectric constant higher than silicon oxide, or a combination thereof. The high-k dielectric material may include, for example, at least one of a metal oxide, a metal oxynitride, a metal silicon oxide, or a metal silicon oxynitride, but the present disclosure is not limited thereto.

The gate insulating patterns GOX may extend along the first sidewalls SS1 of the first active patterns AP1 and along the second sidewalls SS2 of the second active patterns AP2. The gate insulating patterns GOX may be disposed between the first active patterns AP1 and gate capping patterns 143, and between the second active patterns AP2 and the gate capping patterns 143.

In some embodiments, the gate insulating patterns GOX may not be disposed between the first active patterns AP1 and the gate shielding patterns 145, and between the second active patterns AP2 and the gate shielding patterns 145.

From a cross-sectional perspective or view, gate insulating patterns GOX between the first active patterns AP1 and the first wordlines WL1 may be connected to gate insulating patterns GOX between the second active patterns AP2 and the second wordlines WL2. Alternatively, contrary to what is illustrated, the gate insulating patterns GOX between the first active patterns AP1 and the first wordlines WL1 may be separated from the gate insulating patterns GOX between the second active patterns AP2 and the second wordlines WL2.

The gate shielding patterns 145 may be disposed between the first wordlines WL1 and the bitlines BL, and between the second wordlines WL2 and the bitlines BL. The gate shielding patterns 145 may be disposed on the first surfaces WL_S1 of the first wordlines WL1 and second wordlines WL2.

The gate shielding patterns 145 may include upper surfaces 145_S2 and bottom surfaces 145_S1 that are opposite to each other in the third direction DR3. The bottom surfaces 145 _S1 of the gate shielding patterns 145 may face the bitlines BL. The gate shielding patterns 145 may include sidewalls 145_SW that connect the bottom surfaces 145_S1 and the upper surfaces 145_S2.

The first wordlines WL1 and the second wordlines WL2 may be disposed on the upper surfaces 145_S2 of the gate shielding patterns 145. The gate insulating patterns GOX may extend along the upper surfaces 145_S2 of the gate shielding patterns 145.

In some embodiments, the gate shielding patterns 145 may contact the first active patterns AP1 and the second active patterns AP2. The sidewalls 145_SW of the gate shielding patterns 145 may contact the first active patterns AP1 and the second active patterns AP2. In other words, the first sidewalls SS1 of the first active patterns AP1 and the second sidewalls SS2 of the second active patterns AP2 may contact the gate shielding patterns 145.

The first impurity doping regions AP_SDR of the first active patterns AP1 and second active patterns AP2 may overlap with the gate shielding patterns 145 in the second direction DR2. The first impurity doping regions AP_SDR of the first active patterns AP1 and second active patterns AP2 may contact the gate shielding patterns 145.

The gate shielding patterns 145 may include an insulating material doped with the second impurity element. The second impurity element may be an n-type impurity element. The second impurity element may include phosphorus (P), but the present disclosure is not limited thereto. The gate shielding patterns 145 may include a doped second impurity element. The gate shielding patterns 145 may include an insulating material doped with P. For example, the gate shielding patterns 145 may include silicon oxide doped with P. In one example, the gate shielding patterns 145 may include phosphorus silicate glass (PSG), but the present disclosure is not limited thereto.

During the manufacturing process, the phosphorus (P) doped in the gate shielding patterns 145 may diffuse into the first active patterns AP1 and the second active patterns AP2. As a result, the first impurity doping regions AP_SDR of the first active patterns AP1 and second active patterns AP2 may be formed. As the P doped in the gate shielding patterns 145 diffuses into the first active patterns AP1 and the second active patterns AP2, the resistance between the first active patterns AP1 and the bitlines BL, and between the second active patterns AP2 and the bitlines BL, can be reduced.

Referring to FIG. 5, the gate shielding patterns 145 and the first impurity doping regions AP_SDR may include doped phosphorus (P). At the boundaries between the gate shielding patterns 145 and the first impurity doping regions AP_SDR, the concentration (/cm³) of P in the gate shielding patterns 145 is illustrated as being lower than the concentration of P in the first impurity doping regions AP_SDR, but the present disclosure is not limited thereto. The concentration of P in the first impurity doping regions AP_SDR is illustrated as decreasing away from the gate shielding patterns 145, but the present disclosure is not limited thereto.

In some embodiments, the back gate shielding patterns 115 may not include an insulating material doped with an n-type impurity element. For example, the back gate shielding patterns 115 may not include PSG.

Gate separation patterns GSS may be disposed on the bitlines BL. The gate separation patterns GSS may be disposed on the gate shielding patterns 145.

The gate separation patterns GSS may be disposed between the first wordlines WL1 and the second wordlines WL2 in the second direction DR2. The first wordlines WL1 and the second wordlines WL2 may be separated by the gate separation patterns GSS. The gate separation patterns GSS may extend in the first direction DR1 between the first wordlines WL1 and the second wordlines WL2.

The first wordlines WL1 may be disposed between the gate separation patterns GSS and the first active patterns AP1. The gate separation patterns GSS may be disposed on the first sidewalls SS1 of the first active patterns AP1. The second wordlines WL2 may be disposed between the gate separation patterns GSS and the second active patterns AP2. The gate separation patterns GSS may be disposed on the second sidewalls SS2 of the second active patterns AP2.

The gate separation patterns GSS may be formed of an insulating material. For example, the gate separation patterns GSS may include one of silicon oxide, silicon oxynitride, or silicon nitride, but the present disclosure is not limited thereto. The gate separation patterns GSS are illustrated as being single layers, but the present disclosure is not limited thereto. Alternatively, contrary to what is illustrated, the gate separation patterns GSS may include multiple insulating films.

The contact patterns BC may penetrate through or extend into a contact interlayer insulating film 231 and a contact etch stop film 212. The contact patterns BC may be respectively connected to the first active patterns AP1 and the second active patterns AP2. The contact patterns BC may be connected to the second surfaces S2 of the first active patterns AP1 and second active patterns AP2. The contact patterns BC may have various shapes, such as circular, oval, rectangular, square, diamond-shaped, or hexagonal, from a planar perspective.

The contact patterns BC may include a conductive material. For example, the contact patterns BC may include at least one of doped polysilicon, a conductive metal nitride, a conductive metal silicon nitride, a metal carbonitride, a conductive metal silicide, a conductive metal oxide, a 2D material, or a metal.

The contact etch stop film 212 may be disposed on the gate separation patterns GSS and the back gate separation patterns 111. The contact interlayer insulating film 231 and the contact etch stop film 212 may be formed of an insulating material.

Landing pads LP may be disposed on the contact patterns BC. From a planar perspective, the landing pads LP may have various shapes, such as circular, oval, rectangular, square, diamond-shaped, or hexagonal.

Pad separation insulating patterns 235 may be disposed between the landing pads LP. From a planar perspective, the landing pads LP may be arranged in a matrix form along the first and second directions DR1 and DR2. The upper surfaces of the landing pads LP may be substantially coplanar with the upper surfaces of the pad separation insulating patterns 235, but the present disclosure is not limited thereto.

The landing pads LP may include a conductive material. For example, the landing pads LP may include at least one of doped polysilicon, a conductive metal nitride, a conductive metal silicon nitride, a metal carbonitride, a conductive metal silicide, a conductive metal oxide, a 2D material, or a metal.

Contrary to what is illustrated, the semiconductor memory device according to some embodiments may not include the landing pads LP.

The data storage patterns DSP may be respectively disposed on the landing pads LP. The data storage patterns DSP may be electrically connected to the first active patterns AP1 and the second active patterns AP2. As illustrated in FIG. 1, the data storage patterns DSP may be arranged in a matrix form along the first and second directions DR1 and DR2. The data storage patterns DSP may fully or partially overlap with the landing pads LP in the third direction DR3. The data storage patterns DSP may contact all or parts of the upper surfaces of the landing pads LP.

For example, the data storage patterns DSP may be capacitors. The data storage patterns DSP may include a capacitor dielectric film 253 interposed between storage electrodes 251 and plate electrodes 255. For example, the storage electrodes 251 may contact the landing pads LP. From a planar perspective, the storage electrodes 251 may have various shapes, such as circular, oval, rectangular, square, diamond-shaped, or hexagonal.

The data storage patterns DSP may contact all or parts of the upper surfaces of the landing pads LP. The storage electrodes 251 may penetrate or extend into an upper etch stop film 247. The upper etch stop film 247 may be formed of an insulating material. Portions of the storage electrodes 251 are illustrated as being recessed into the landing pads LP, but the present disclosure is not limited thereto.

The storage electrodes 251 and the plate electrodes 255 may include, for example, at least one of a conductive semiconductor material, a conductive metal nitride, a conductive metal silicon nitride, a metal carbonitride, a conductive metal silicide, a conductive metal oxide, or a metal. The capacitor dielectric film 253 may include at least one of a ferroelectric material, an antiferroelectric material, or a paraelectric material. For example, the capacitor dielectric film 253 may include one of a ferroelectric material, an antiferroelectric material, a paraelectric material, a combination of a ferroelectric material and an antiferroelectric material, a combination of a ferroelectric material and a paraelectric material, a combination of an antiferroelectric material and a paraelectric material, or a combination of a ferroelectric material, an antiferroelectric material, and a paraelectric material.

Alternatively, the data storage patterns DSP may be variable resistance patterns that can switch between two resistance states in response to electrical pulses applied to memory elements. For example, the data storage patterns DSP may include a phase-change material whose crystalline state changes depending on the amount of current, a perovskite compound, a transition metal oxide, a magnetic material, a ferromagnetic material, or an antiferromagnetic material.

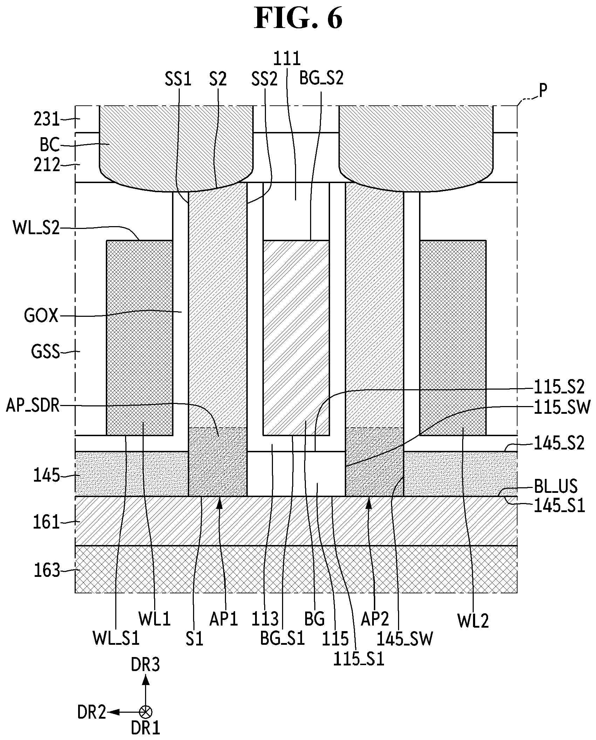

FIG. 6 is a diagram for explaining a semiconductor memory device according to some embodiments. For convenience, the embodiment of FIG. 6 will hereinafter be described, focusing mainly on the differences from what has been explained with reference to FIGS. 1 through 5. For reference, FIG. 6 is an enlarged cross-sectional view of part P of FIG. 2.

Referring to FIG. 6, in the semiconductor memory device according to some embodiments, back gate shielding patterns 115 may contact first active patterns AP1 and second active patterns AP2.

The back gate shielding patterns 115 may include upper surfaces 115_S2 and bottom surfaces 115_S1 that are opposite to each other in a third direction DR3. The bottom surfaces 115_S1 of the back gate shielding patterns 115 may face bitlines BL. The back gate shielding patterns 115 may include sidewalls 115_SW that connect the bottom surfaces 115_S1 and the upper surfaces 115_S2 of the back gate shielding patterns 115.

The sidewalls 115_SW of the back gate shielding patterns 115 may contact the first active patterns AP1 and the second active patterns AP2. In other words, second sidewalls SS2 of the first active pattern AP1 and first sidewalls SS1 of the second active patterns AP2 may contact the back gate shielding patterns 115.

Back gate insulating patterns 113 may be disposed between back gate electrodes BG and the back gate shielding patterns 115. The back gate insulating patterns 113 may extend along the upper surfaces 115_S2 of the back gate shielding patterns 115. If the back gate insulating patterns 113 and the back gate shielding patterns 115 are formed of the same insulating material, the boundaries between the back gate insulating patterns 113 and the back gate shielding patterns 115 may not be distinguishable.

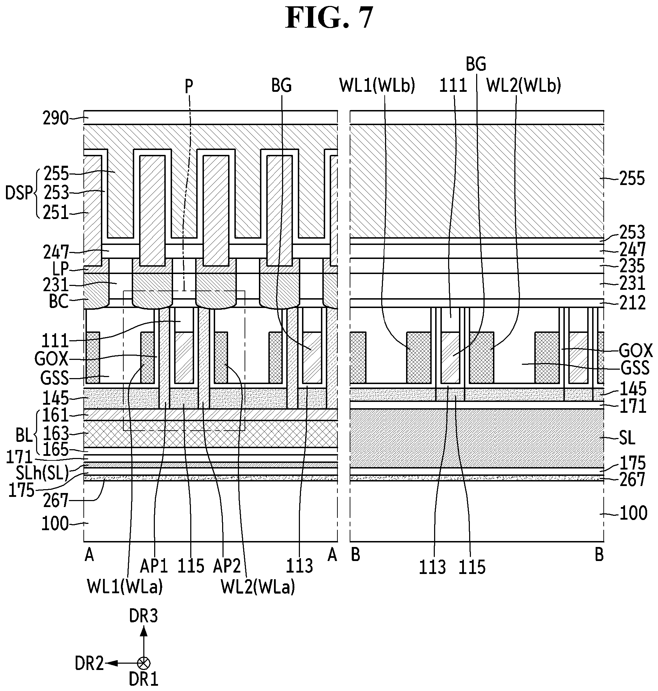

FIGS. 7 through 9 are diagrams for explaining a semiconductor memory device according to some embodiments. For convenience, the embodiment of FIGS. 7 through 9 will hereinafter be described, focusing mainly on the differences from what has been explained with reference to FIGS. 1 through 6.

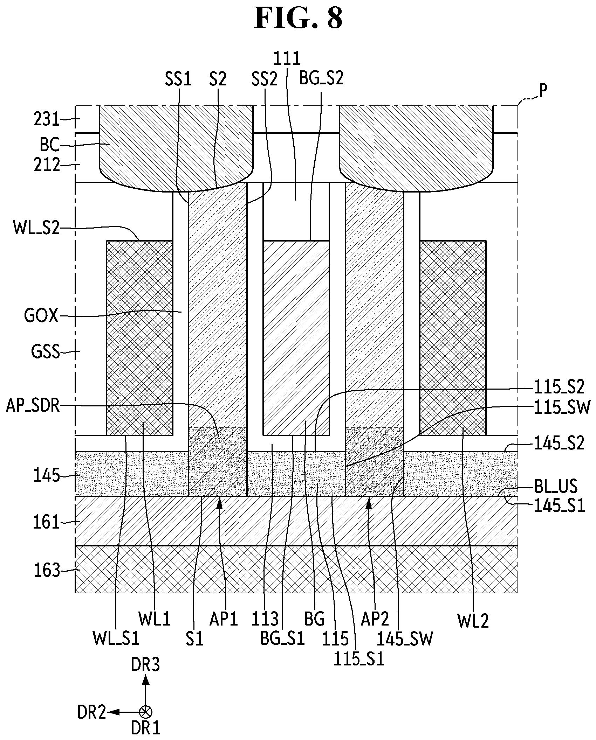

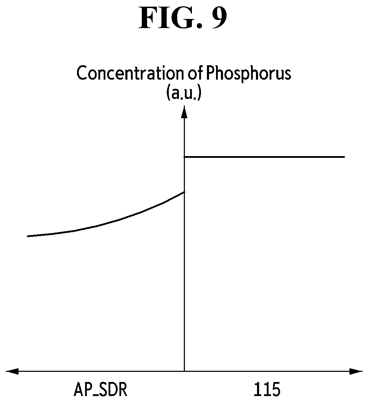

For reference, FIG. 7 is a cross-sectional view taken along lines A - A and B - B of FIG. 1. FIG. 8 is an enlarged cross-sectional view of part P of FIG. 7. FIG. 9 is an example diagram for explaining the concentration of phosphorus (P) in back gate shielding patterns and first impurity doping regions of FIG. 8.

Referring to FIGS. 7 through 9, in the semiconductor memory device according to some embodiments, back gate shielding patterns 115 may include an insulating material doped with a third impurity element, which is an n-type impurity element.

The third impurity element may include phosphorus (P), but the present disclosure is not limited thereto. The back gate shielding patterns 115 may include a doped third impurity element. The back gate shielding patterns 115 may include an insulating material doped with P. For example, the back gate shielding patterns 115 may include silicon oxide doped with P. In one example, the back gate shielding patterns 115 may include PSG, but the present disclosure is not limited thereto.

First impurity doping regions AP _SDR of first active patterns AP1 and first impurity doping regions AP_SDR of second active patterns AP2 may overlap with the back gate shielding patterns 115 doped with phosphorus (P) in a second direction DR2. The first impurity doping regions AP_SDR of the first active patterns AP1 and second active patterns AP2 may contact the back gate shielding patterns 115.

During the manufacturing process, the phosphorus (P) doped in the back gate shielding patterns 115 may diffuse into the first active patterns AP1 and the second active patterns AP2. As a result, the first impurity doping regions AP_SDR of the first active patterns AP1 and second active patterns AP2 may be formed.

Referring to FIG. 9, the back gate shielding patterns 115 and the first impurity doping regions AP_SDR may include doped phosphorus (P). At the boundaries between the back gate shielding patterns 115 and the first impurity doping regions AP_SDR, the concentration of P in the back gate shielding patterns 115 is illustrated as being lower than the concentration of P in the first impurity doping regions AP_SDR, but the present disclosure is not limited thereto. The concentration of P in the first impurity doping regions AP_SDR is illustrated as decreasing away from the back gate shielding patterns 115, but the present disclosure is not limited thereto.

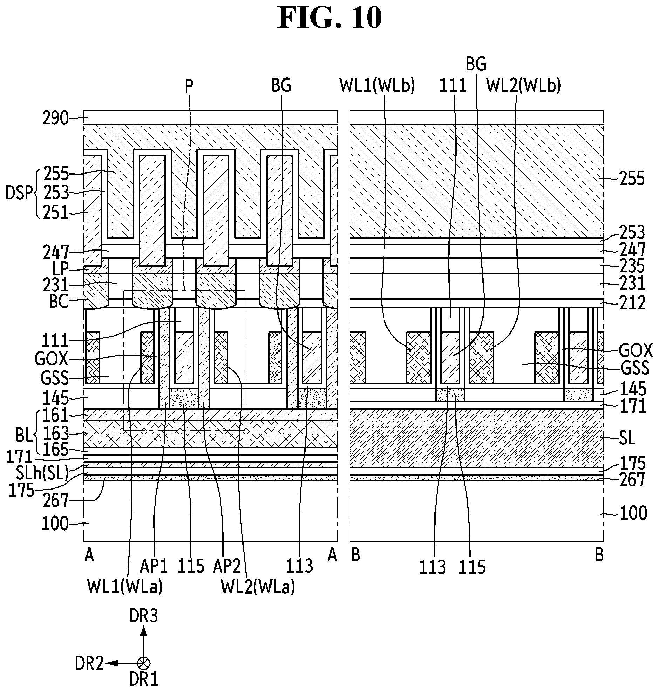

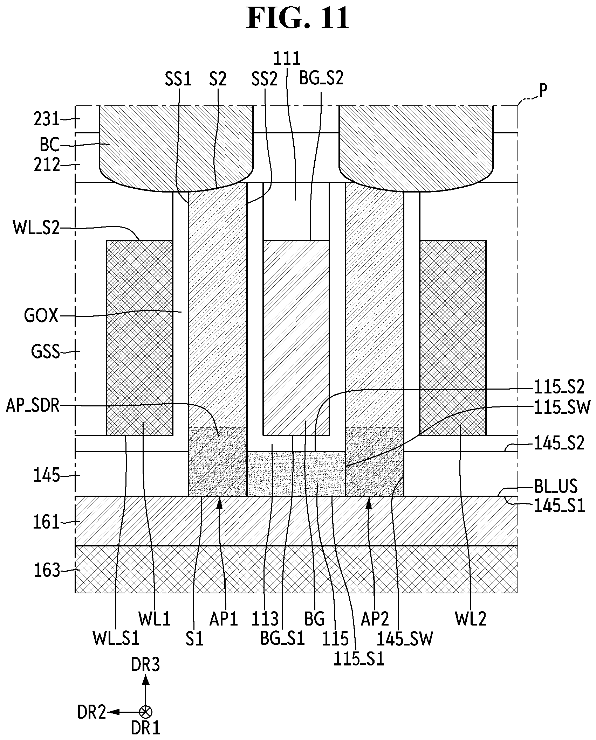

FIGS. 10 and 11 are diagrams for explaining a semiconductor memory device according to some embodiments. For convenience, the embodiment of FIGS. 10 and 11 will hereinafter be described, focusing mainly on the differences from what has been explained with reference to FIGS. 1 through 9. For reference, FIG. 10 is a cross-sectional view taken along lines A - A and B - B of FIG. 1. FIG. 11 is an enlarged cross-sectional view of part P of FIG. 10.

Referring to FIGS. 10 and 11, in the semiconductor memory device according to some embodiments, gate shielding patterns 145 may not include an insulating material doped with an n-type impurity element.

For example, the gate shielding patterns 145 may not include Phosphorus Silicate Glass (PSG). The gate shielding patterns 145 may include, for example, at least one of silicon oxide, silicon oxynitride, or silicon nitride, but the present disclosure is not limited thereto.

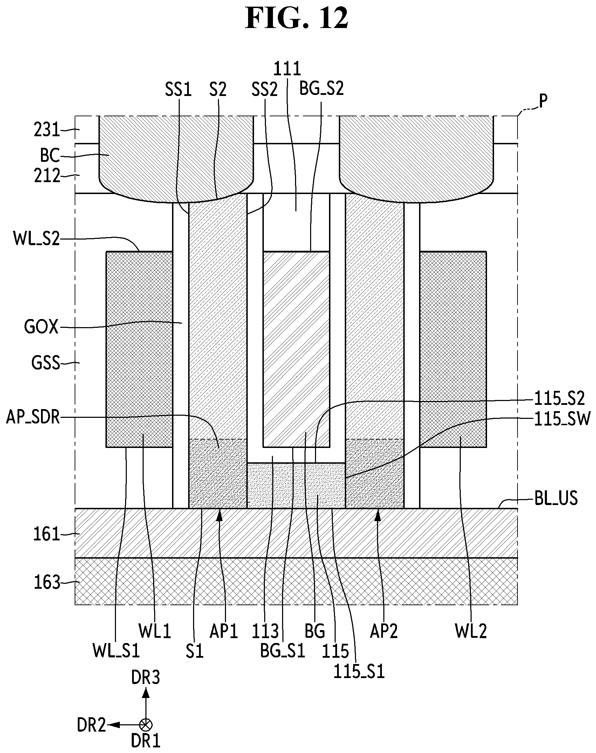

FIG. 12 is a diagram for explaining a semiconductor memory device according to some embodiments. For convenience, the embodiment of FIGS. 10 and 11 will hereinafter be described, focusing mainly on the differences from what has been explained with reference to FIGS. 10 and 11. For reference, FIG. 12 is an enlarged cross-sectional view of part P of FIG. 10.

Referring to FIG. 12, the semiconductor memory device according to some embodiments may not include gate shielding patterns ("145" of FIG. 10).

Gate separation patterns GSS may be disposed on first surfaces WL_S1 of first wordlines WL1 and first surfaces WL_S1 of second wordlines WL2. Gate insulating patterns GOX may not extend along the first surfaces WL_S1 of the first wordlines WL1. The gate insulating patterns GOX may not extend along the first surfaces WL_S1 of the second wordlines WL2.

The gate insulating patterns GOX may be disposed between first active patterns AP1 and the gate separation patterns GSS, and between second active patterns AP2 and the gate separation patterns GSS.

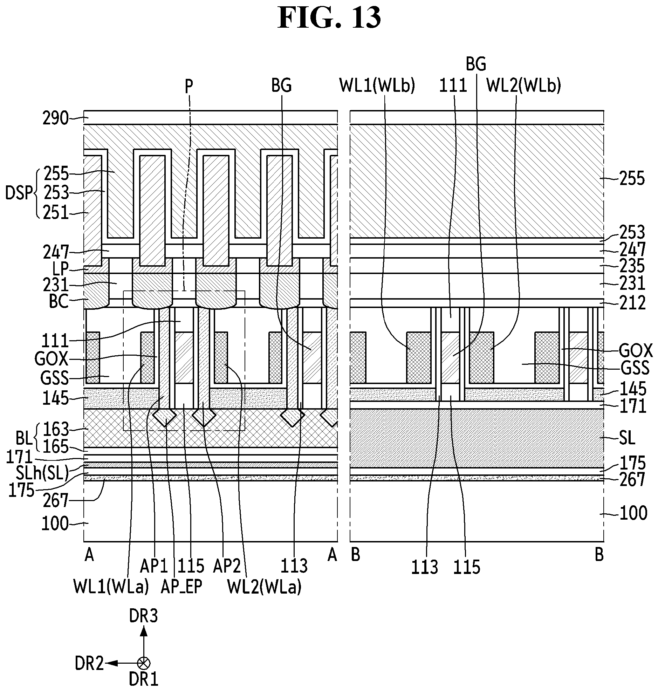

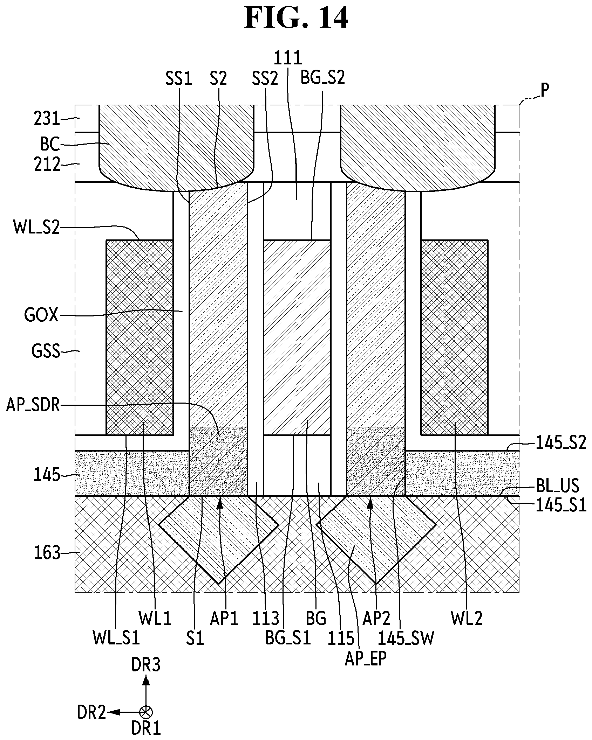

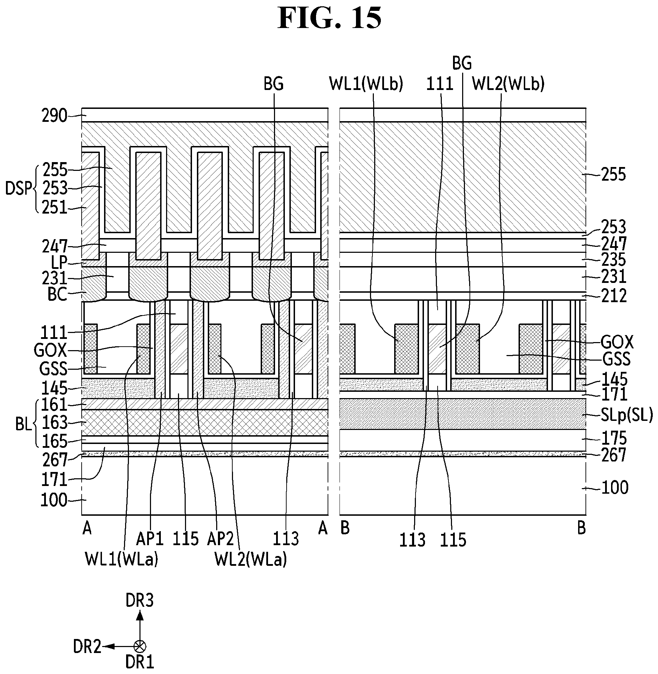

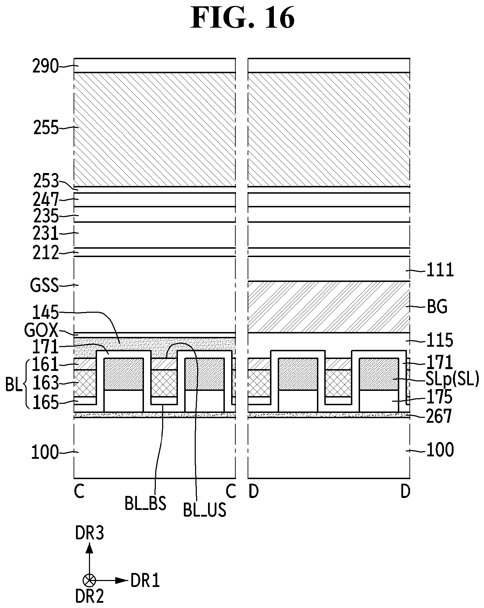

FIGS. 13 and 14 are diagrams for explaining a semiconductor memory device according to some embodiments. FIGS. 15 and 16 are diagrams for explaining a semiconductor memory device according to some embodiments. For convenience, the embodiments of FIGS. 13 through 16 will hereinafter be described, focusing mainly on the differences from what has been explained with reference to FIGS. 1 through 5.

For reference, FIG. 14 is an enlarged cross-sectional view of part P of FIG. 13.

Referring to FIGS. 13 and 14, the semiconductor memory device according to some embodiments may further include connection semiconductor patterns AP_EP.

The connection semiconductor patterns AP_EP may be disposed on first active patterns AP1 and second active patterns AP2. The connection semiconductor patterns AP_EP may contact the first active patterns AP1 and the second active patterns AP2. For example, the connection semiconductor patterns AP_EP may contact first surfaces S1 of the first active patterns AP1 and second active patterns AP2.

The connection semiconductor patterns AP_EP may be disposed between the first active pattern AP1 and bitlines BL, and between the second active patterns AP2 and the bitlines BL. The bitlines BL may cover or overlap the connection semiconductor patterns AP_EP.

The connection semiconductor patterns AP_EP may include a semiconductor epitaxial pattern. The connection semiconductor patterns AP_EP may include, for example, an elemental semiconductor material such as Si or Ge. Additionally, the connection semiconductor patterns AP_EP may include a binary or ternary compound containing at least two elements selected from carbon (C), Si, Ge, and tin (Sn), or a compound obtained by doping the binary or ternary compound with a Group IV element.

The bitlines BL are illustrated as including metal patterns 163 without semiconductor patterns 161, but the present disclosure is not limited thereto. Contrary to what is illustrated, the bitlines BL may include both the semiconductor patterns 161 and the metal patterns 163.

Referring to FIGS. 15 and 16, in the semiconductor memory device according to some embodiments, shielding conductive patterns SL may include a plurality of shielding conductive line patterns SLp without a shielding conductive plate SLh.

The shielding conductive patterns SL may not be disposed on bottom surfaces BL_BS of bitlines BL. For example, a shielding insulating capping film 175 may contact the shielding conductive line patterns SLp.

The shielding insulating capping film 175 may have a linear shape extending in a second direction DR2 along the shielding conductive line patterns SLp.

Alternatively, contrary to what is illustrated, the shielding insulating capping film 175 may have a flat plate shape. In other words, the shielding insulating capping film 175 may overlap with the shielding conductive line patterns SLp and the bitlines BL in a third direction DR3.

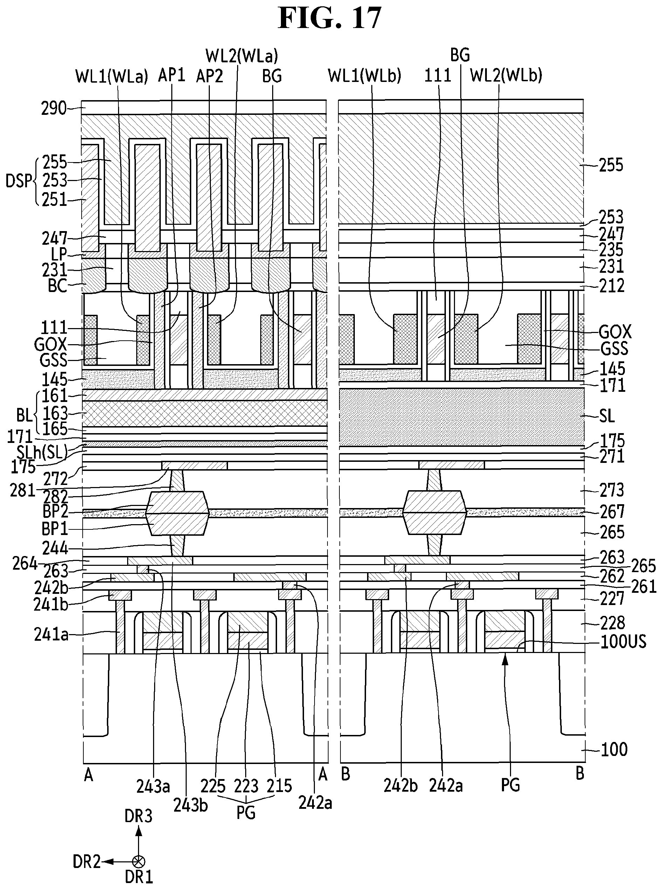

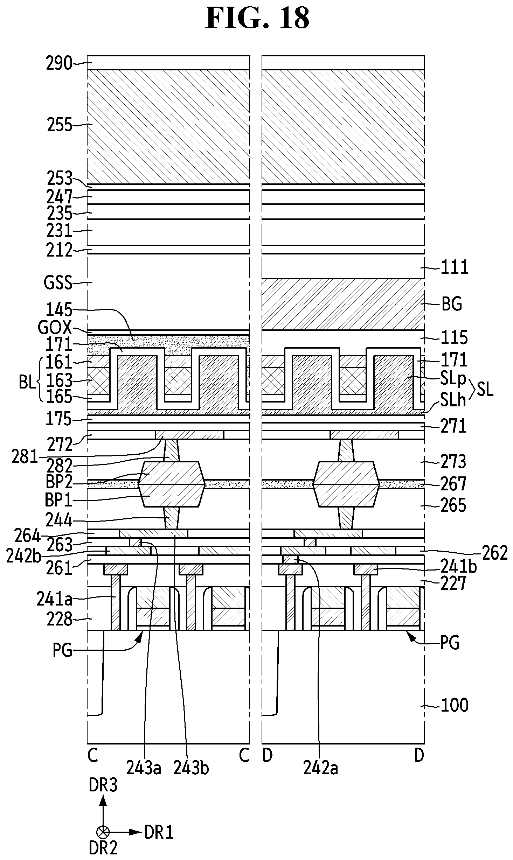

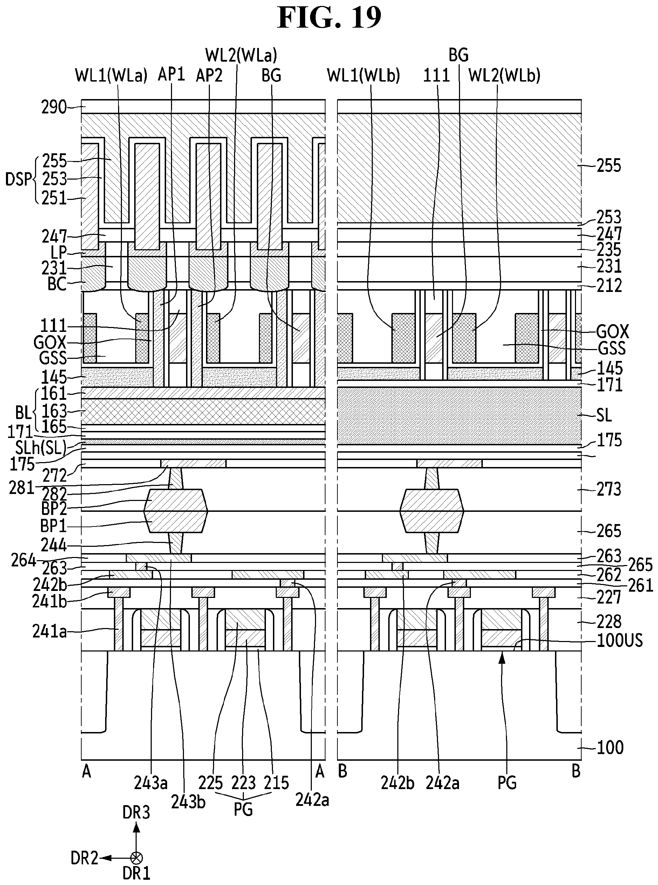

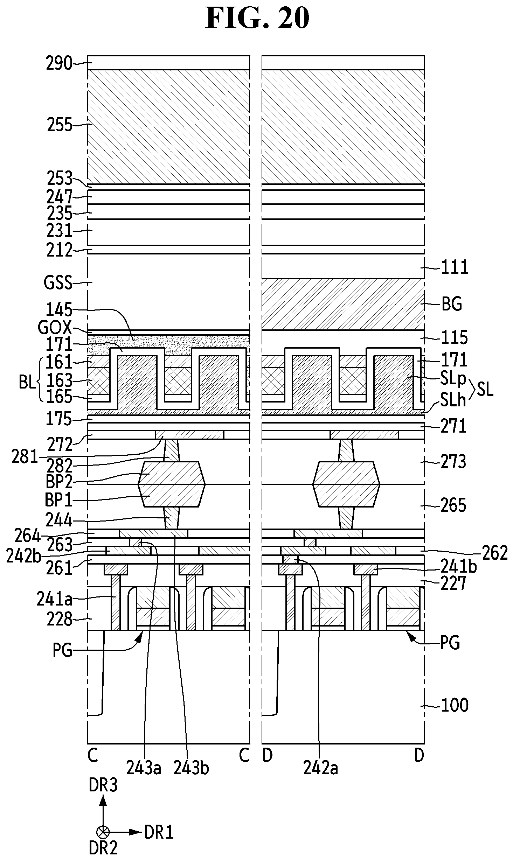

FIGS. 17 and 18 are diagrams for explaining a semiconductor memory device according to some embodiments. FIGS. 19 and 20 are diagrams for explaining a semiconductor memory device according to some embodiments. For convenience, the embodiments of FIGS. 17 through 20 will hereinafter be described, focusing mainly on the differences from what has been explained with reference to FIGS. 1 through 5.

For reference, FIGS. 17 and 19 are cross-sectional views taken along lines A - A and B - B of FIG. 1, respectively. FIGS. 18 and 20 are cross-sectional views taken along lines C - C and D - D of FIG. 1, respectively.

Referring to FIGS. 17 through 20, the semiconductor memory device according to in some embodiments may further include a peri-gate structure PG, which is disposed between a substrate 100 and bitlines BL.

The peri-gate structure PG may be disposed on the substrate 100. For example, the peri-gate structure PG may be disposed on an upper surface 100US of the substrate 100. The peri-gate structure PG may be disposed across both a cell array region and a peripheral circuit region of the substrate 100. In other words, part of the peri-gate structure PG may be disposed in the cell array region, and another part of the peri-gate structure PG may be disposed in the peripheral circuit region.

The peri-gate structure PG may be included in sensing transistors, transfer transistors, driving transistors, etc. For example, portions of the peri-gate structure PG included in sensing transistors may be disposed in the cell array region of the substrate 100, but the present disclosure is not limited thereto. The types of transistors in the peripheral circuitry within the cell array region of the substrate 100 may vary depending on the design layout of the semiconductor memory device according to some embodiments.

The peri-gate structure PG may include a peri-gate insulating film 215, peri-lower conductive patterns 223, and peri-upper conductive patterns 225. The peri-gate insulating film 215 may include a silicon oxide film, a silicon oxynitride film, a high-k dielectric film with a dielectric constant higher than silicon oxide, or a combination thereof. The high-k dielectric film may include, for example, at least one of a metal oxide, a metal oxynitride, a metal silicon oxide, or a metal silicon oxynitride, but the present disclosure is not limited thereto.

The peri-lower conductive patterns 223 and the peri-upper conductive patterns 225 may each include a conductive material. For example, the peri-lower conductive patterns 223 and the peri-upper conductive patterns 225 may each include at least one of a doped semiconductor material, a conductive metal nitride, a conductive metal silicon nitride, a metal carbonitride, a conductive metal silicide, a conductive metal oxide, a 2D material, or a metal. The peri-gate structure PG is illustrated as including multiple conductive patterns, but the present disclosure is not limited thereto.

Although not illustrated, the peri-gate structure PG may further include peri-gate mask patterns disposed on the peri-upper conductive patterns 225. The peri-gate mask patterns may be formed of an insulating material.

A first peri-lower insulating film 227 and a second peri-lower insulating film 228 may be disposed on the upper surface 100US of the substrate 100. The first and second peri-lower insulating films 227 and 228 may include an insulating material.

Peri-contact plugs 241a and peri-wiring lines 241b may be disposed within the first and second peri-lower insulating films 227 and 228. The peri-contact plugs 241a and the peri-wiring lines 241b may be connected to the conductive patterns (223 and 225) of the peri-gate structure PG. Although not illustrated, the peri-contact plugs 241a and the peri-wiring lines 241b may be connected to source/drain regions disposed on at least one side of the peri-gate structure PG.

The peri-contact plugs 241a and the peri-wiring lines 241b are illustrated as being different layers, but the present disclosure is not limited thereto. The boundaries between the peri-contact plugs 241a and the peri-wiring lines 241b may not be distinguishable. The peri-contact plugs 241a and the peri-wiring lines 241b may include a conductive material.

A first peri-upper insulating film 261 and a second peri-upper insulating film 262 may be disposed on the peri-contact plugs 241a and the peri-wiring lines 241b. The first and second peri-upper insulating films 261 and 262 may include an insulating material. Alternatively, contrary to what is illustrated, a single insulating film may be disposed on the peri-contact plugs 241a and the peri-wiring lines 241b.

A first peri-connection structure (242a and 242b) may be connected to the peri-wiring lines 241b. The first peri-connection structure (242a and 242b) may include first peri-connection vias 242a and first peri-connection wires 242b. The first peri-connection vias 242a and the first peri-connection wires 242b may include a conductive material. The first peri-connection vias 242a and the first peri-connection wires 242b are illustrated as being different layers, but the present disclosure is not limited thereto.

The third and fourth peri-upper insulating films 263 and 264 may be disposed on the first peri-connection structure (242a and 242b). The third and fourth peri-upper insulating films 263 and 264 may include an insulating material. Alternatively, contrary to what is illustrated, a single insulating film may be disposed on the first peri-connection structure (242a and 242b).

A second peri-connection structure (243a and 243b) may be connected to the first peri-connection wires 242b. The second peri-connection structure (243a and 243b) may include second peri-connection vias 243a and second peri-connection wires 243b. The second peri-connection vias 243a and the second peri-connection wires 243b may include a conductive material. The second peri-connection vias 243a and the second peri-connection wires 243b are illustrated as being different layers, but the present disclosure is not limited thereto.

The first peri-connection structure (242a and 242b) and the second peri-connection structure (243a and 243b) are illustrated as being disposed on the peri-gate structure PG, but the present disclosure is not limited thereto. Alternatively, contrary to what is illustrated, only a single peri-connection structure may be disposed on the peri-gate structure PG.

A fifth peri-upper insulating film 265 may be disposed on the second peri-connection structure (243a and 243b). The fifth peri-upper insulating film 265 may include an insulating material.

Lower bonding pads BP1 may be disposed on the peri-gate structure PG. The lower bonding pads BP1 may be connected to the second peri-connection structure (243a and 243b).

For example, at least one of the lower bonding pads BP1 may be connected to the peri-gate structure PG. At least another one of the lower bonding pads BP1 may be connected to source/drain regions disposed on at least one side of the peri-gate structure PG.

Lower pad plugs 244 may connect the lower bonding pads BP1 and the second peri-connection wires 243b. The lower bonding pads BP1 and the lower pad plugs 244 may be disposed within the fifth peri-upper insulating film 265.

First, second, and third cell lower insulating films 271, 272, and 273 may be disposed on the fifth peri-upper insulating film 265. The first, second, and third cell lower insulating films 271, 272, and 273 may be disposed on the lower bonding pads BP1.

The second cell lower insulating film 272 may be disposed between the first cell lower insulating film 271 and the third cell lower insulating film 273. The third cell lower insulating film 273 may be disposed between the second cell lower insulating film 272 and the fifth peri-upper insulating film 265. The first, second, and third cell lower insulating films 271, 272, and 273 may include an insulating material.

Upper bonding pads BP2 may be disposed on the lower bonding pads BP1. The upper bonding pads BP2 may be disposed on the fifth peri-upper insulating film 265.

The upper bonding pads BP2 may be connected to the lower bonding pads BP1. The upper bonding pads BP2 may contact the lower bonding pads BP1.

Cell connection wires 281 may be disposed on the upper bonding pads BP2. The cell connection wires 281 may be disposed between the upper bonding pads BP2 and the bitlines BL. The cell connection wires 281 may be disposed between the upper bonding pads BP2 and shielding conductive patterns SL.

Although not illustrated, the cell connection wires 281 may be connected to at least one of the bitlines BL or the shielding conductive patterns SL.

Cell connection wires 281 disposed on a single metal level are illustrated as being disposed between the upper bonding pads BP2 and the bitlines BL, but the present disclosure is not limited thereto. Multiple cell connection wirings 281 disposed on different metal levels may be disposed between the upper bonding pads BP2 and the bitlines BL.

Upper pad plugs 282 may connect the upper bonding pads BP2 and the cell connection wires 281. The upper bonding pads BP2 may be connected to the cell connection wires 281 through the upper pad plugs 282.

The upper bonding pads BP2 and the upper pad plugs 282 may be disposed within the third cell lower insulating film 273. The cell connection wires 281 may be disposed within the second cell lower insulating film 272.

The upper pad plugs 282 and the lower pad plugs 244 may include a conductive material that includes metal. The lower bonding pads BP1 and the upper bonding pads BP2 may each include a conductive material that includes a metal. The cell connection wires 281 may include a conductive material that includes a metal.

The lower bonding pads BP1 and the upper bonding pads BP2 are each illustrated as being single layers, but the present disclosure is not limited thereto. The upper pad plugs 282 and the lower pad plugs 244 are each illustrated as being single layers, but the present disclosure is not limited thereto. The cell connection wires 281 are illustrated as being single layers, but the present disclosure is not limited thereto.

The shielding conductive patterns SL and the bitlines BL may be disposed on the peri-gate structure PG. The shielding conductive patterns SL and the bitlines BL may be disposed on the upper bonding pads BP2. For example, the shielding conductive patterns SL and the bitlines BL may be disposed on the cell connection wires 281.

The first cell lower insulating film 271 may be disposed between the bitlines BL and the cell connection wires 281, and between the shielding conductive patterns SL and the cell connection wires 281. The first cell lower insulating film 271 may be disposed between a shielding insulating liner 171 and the second cell lower insulating film 272, and between a shielding insulating capping film 175 and the second cell lower insulating film 272.

A cell upper insulating film 290 may be disposed on data storage patterns DSP. The cell upper insulating film 290 may include an insulating material.

In FIGS. 17 and 18, a bonding insulating film 267 may be disposed between the third cell lower insulating film 273 and the fifth peri-upper insulating film 265. The bonding insulating film 267 may be disposed between the peri-gate structure PG and the shielding conductive patterns SL.

The bonding insulating film 267 may be disposed along the extension lines of the interfaces between the lower bonding pads BP1 and the upper bonding pads BP2. The interfaces between the lower bonding pads BP1 and the upper bonding pads BP2 may correspond to the boundaries between the lower bonding pads BP1 and the upper bonding pads BP2.

In FIGS. 19 and 20, the bonding insulating film 267 of FIGS. 17 and 18 may not be disposed along the extension lines of the interfaces between the lower bonding pads BP1 and the upper bonding pads BP2. The third cell lower insulating film 273 may contact the fifth peri-upper insulating film 265.

At the interfaces between the lower bonding pads BP1 and the upper bonding pads BP2, the width of the lower bonding pads BP1 may be the same as the width of the upper bonding pads BP2. Alternatively, contrary to what is illustrated, at the interfaces between the lower bonding pads BP1 and the upper bonding pads BP2, the width of the lower bonding pads BP1 may differ from the width of the upper bonding pads BP2.

At the interfaces between the lower bonding pads BP1 and the upper bonding pads BP2, the lower bonding pads BP1 may be aligned with the upper bonding pads BP2. Alternatively, contrary to what is illustrated, at the interfaces between the lower bonding pads BP1 and the upper bonding pads BP2, the lower bonding pads BP1 may be misaligned with the upper bonding pads BP2.

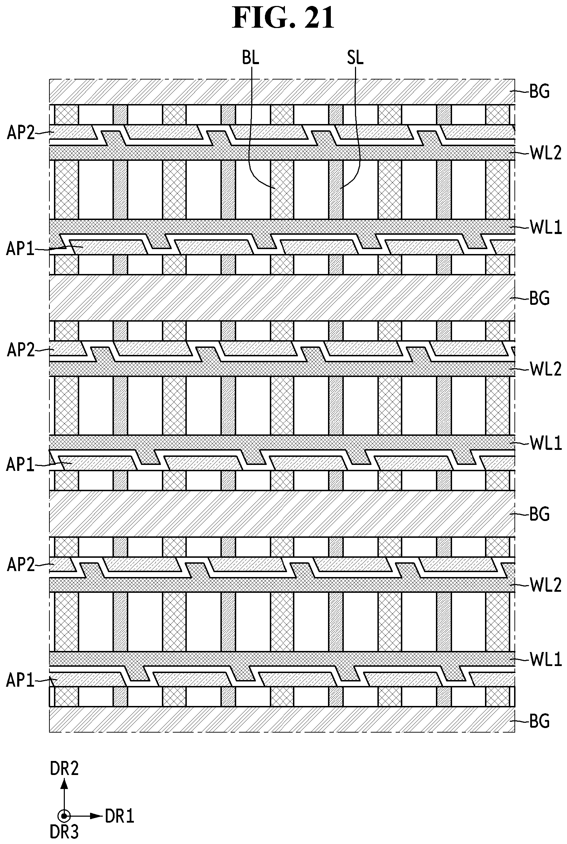

FIGS. 21 through 24 are diagrams for explaining semiconductor memory devices according to some embodiments. For convenience, the embodiments of FIGS. 21 through 24 will hereinafter be described, focusing mainly on the differences from what has been explained with reference to FIGS. 1 through 20.

Referring to FIG. 21, first active patterns AP1 and second active patterns AP2 may be alternately arranged in an oblique direction with respect to first and second directions DR1 and DR2. Here, the oblique direction may be parallel to the upper surface of a substrate 100.

From a planar perspective, the first active patterns AP1 and the second active patterns AP2 may have a parallelogram or diamond shape. Since the first active patterns AP1 and the second active patterns AP2 are arranged in an oblique direction, coupling between the first active patterns AP1 and the second active patterns AP2 that face the first active patterns AP1 in the second direction DR2 can be reduced.

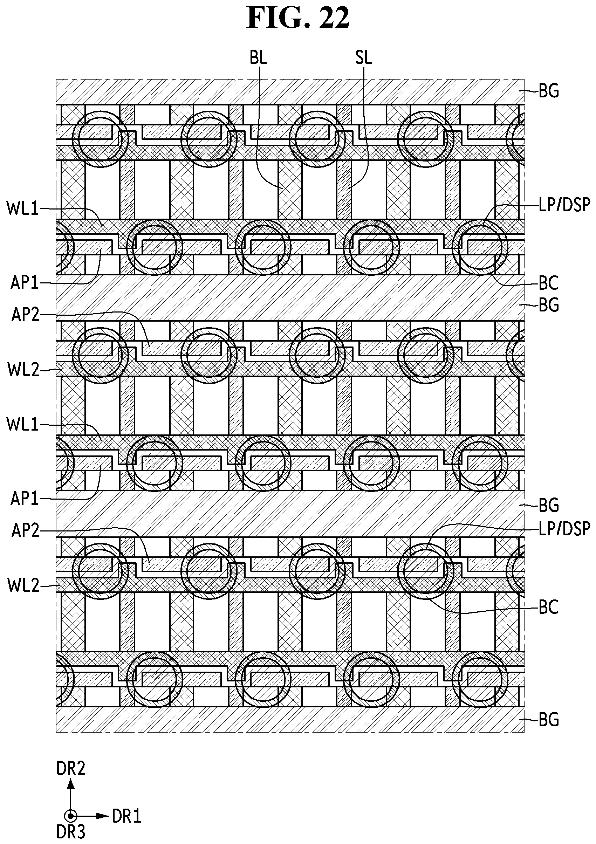

Referring to FIG. 22, from a planar perspective, landing pads LP and data storage patterns DSP may be arranged in a zigzag or honeycomb fashion.

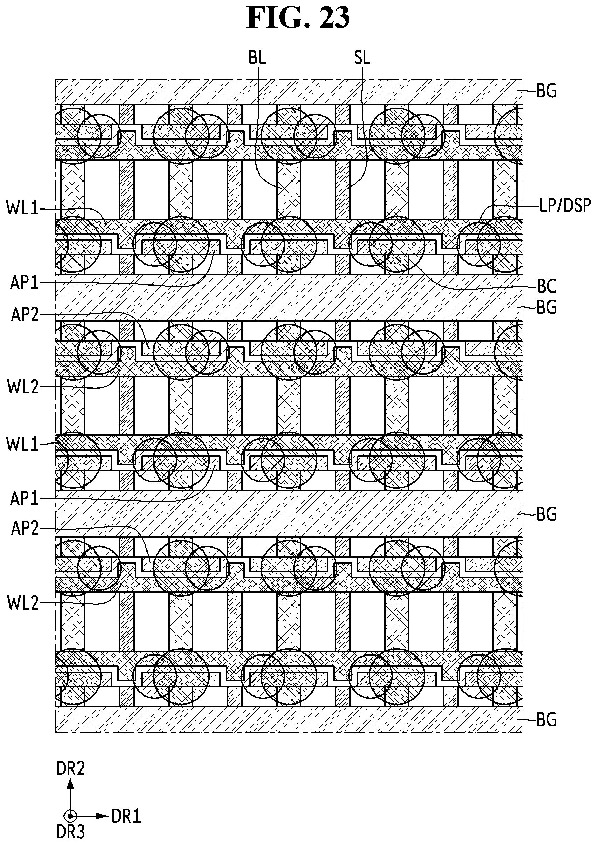

Referring to FIG. 23, from a planar perspective, data storage patterns DSP may be arranged misaligned with landing pads LP.

The data storage patterns DSP may contact parts of the landing pads LP.

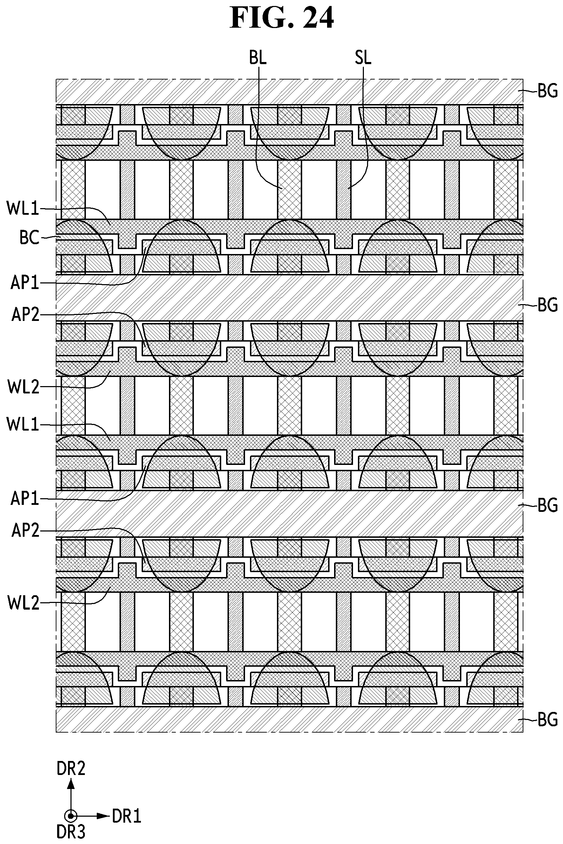

Referring to FIG. 24, from a planar perspective, contact patterns BC disposed on first active patterns AP1 and second active patterns AP2 may have a semicircular or semi-elliptical shape.

From a planar perspective, the contact patterns BC may be symmetrically arranged with each other across back gate electrodes BG.

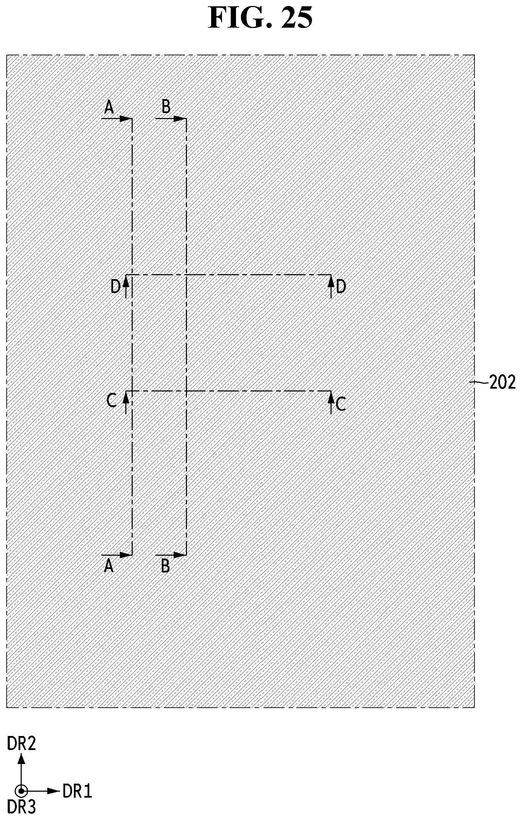

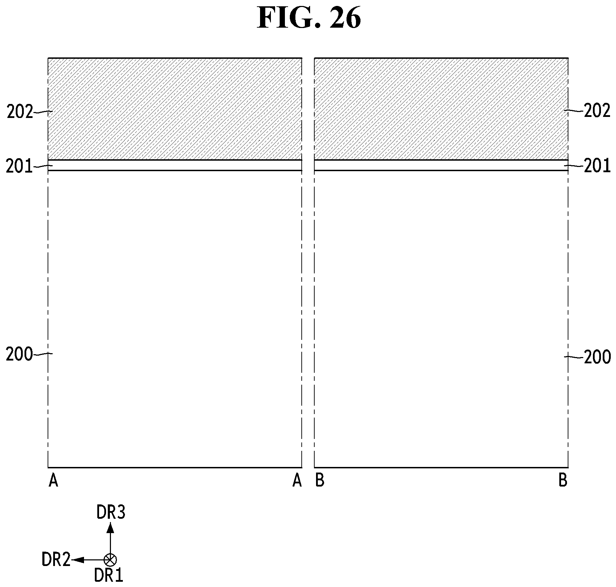

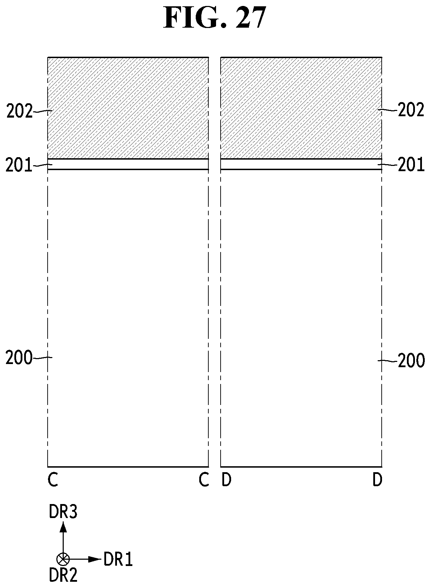

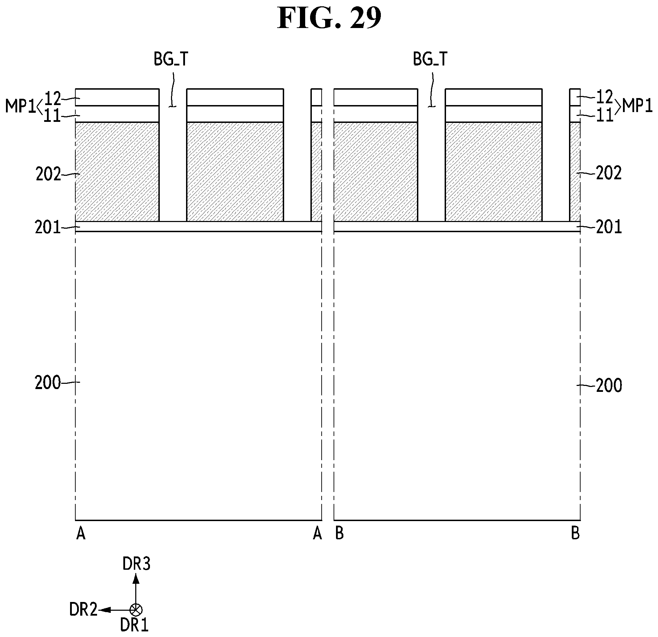

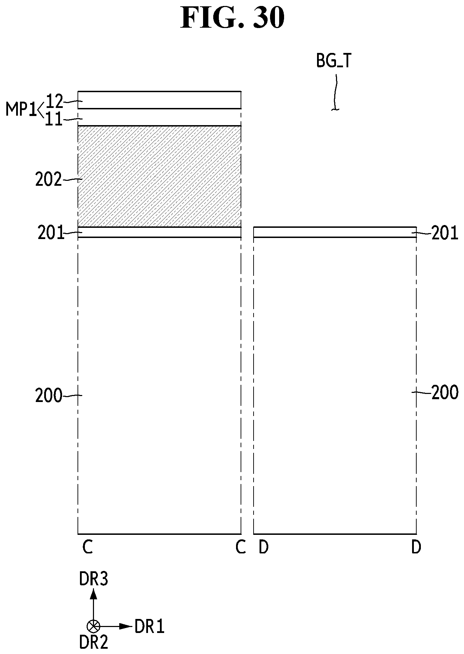

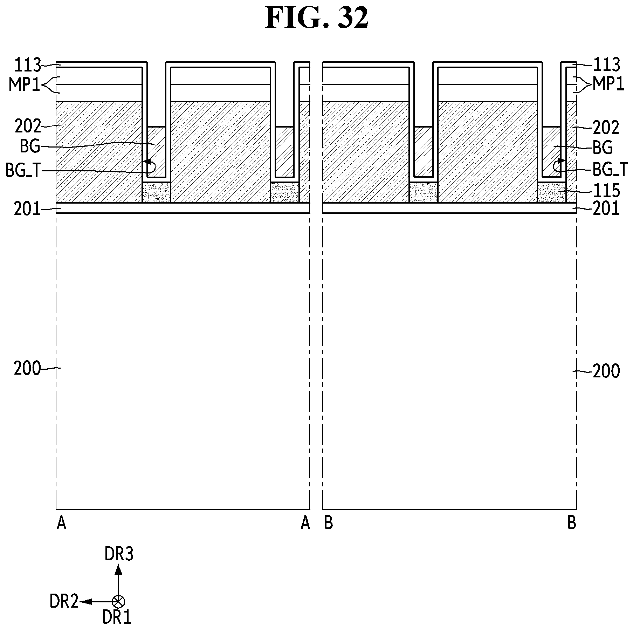

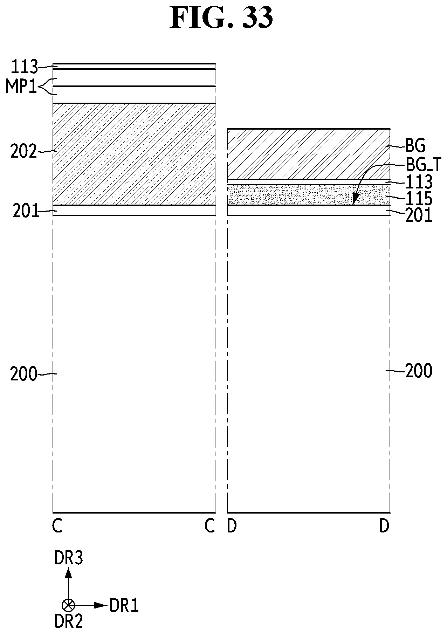

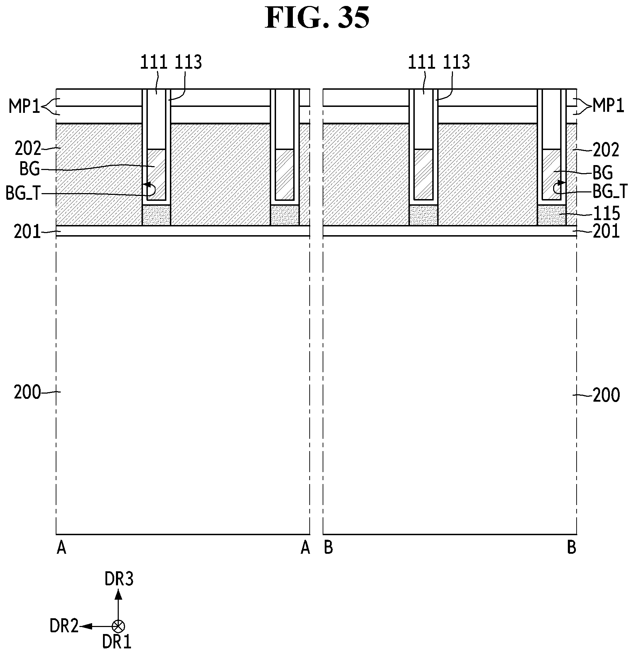

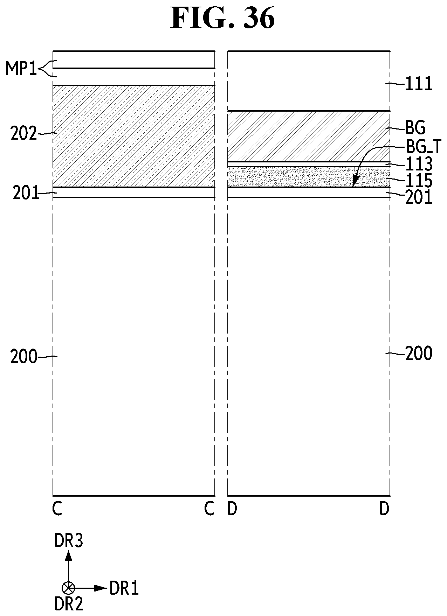

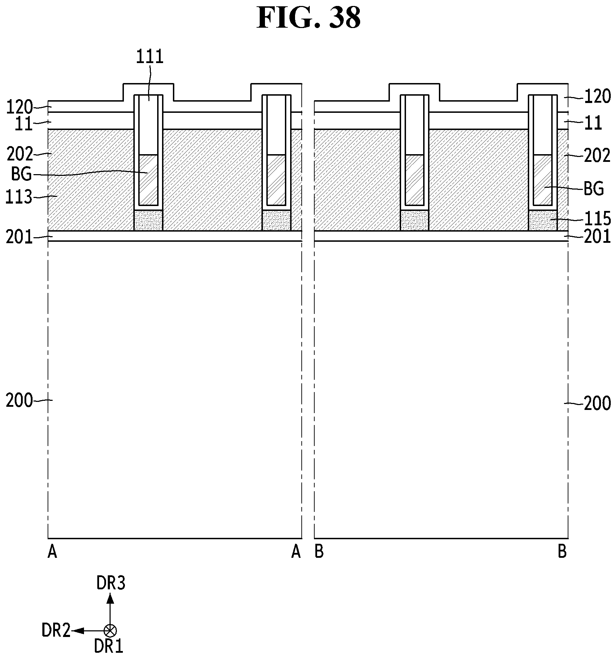

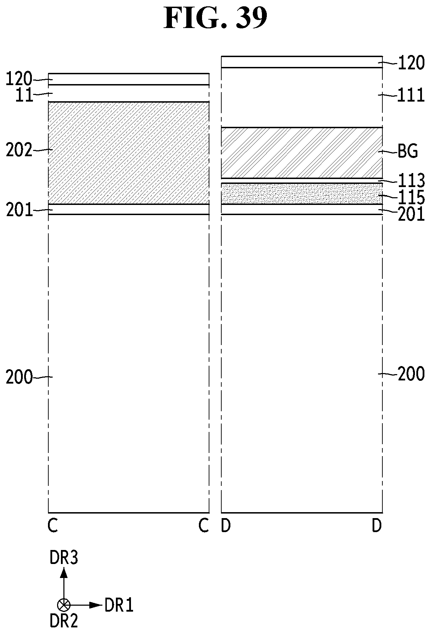

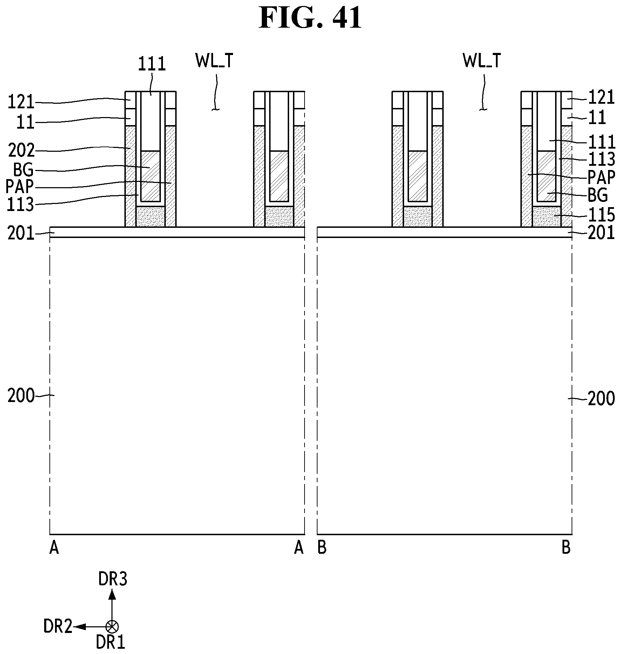

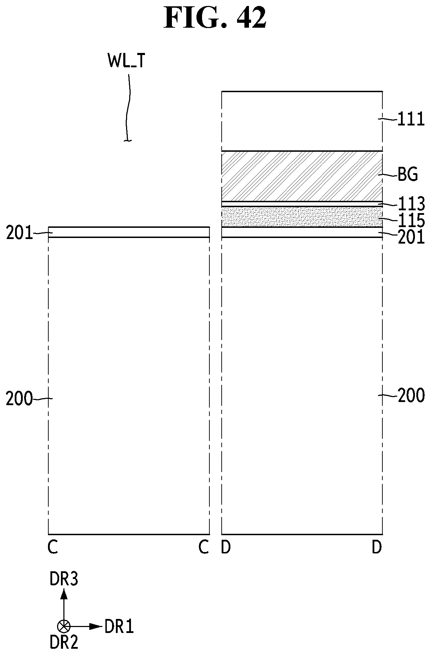

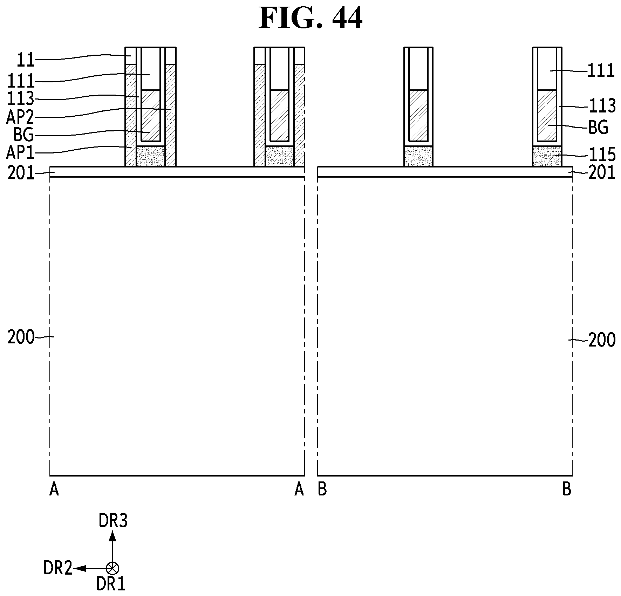

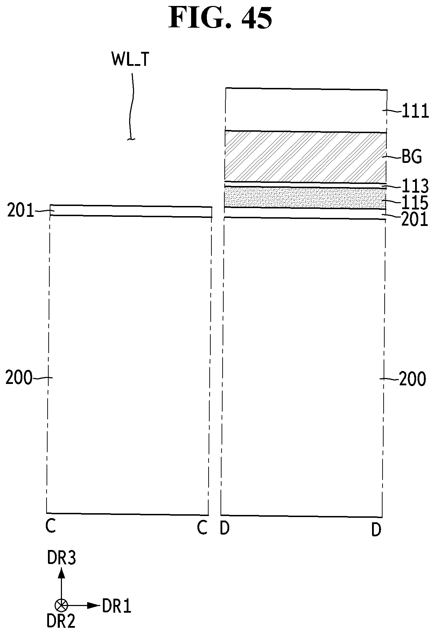

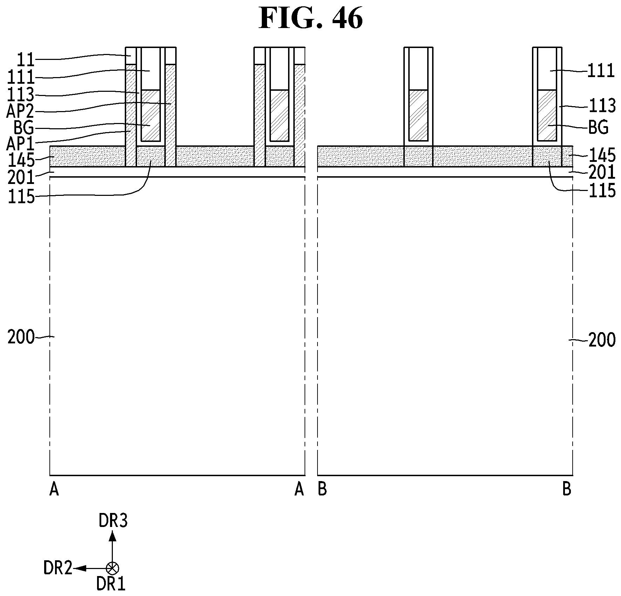

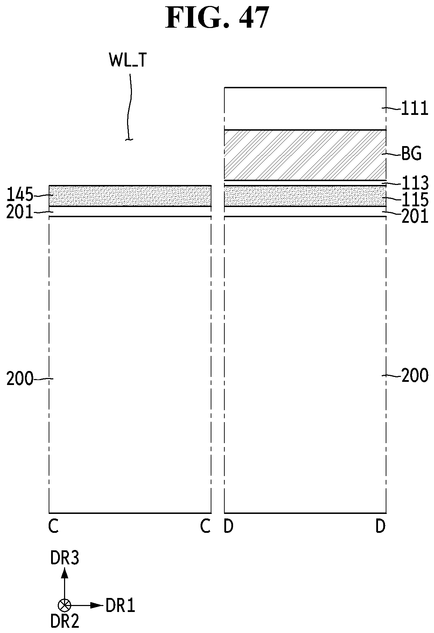

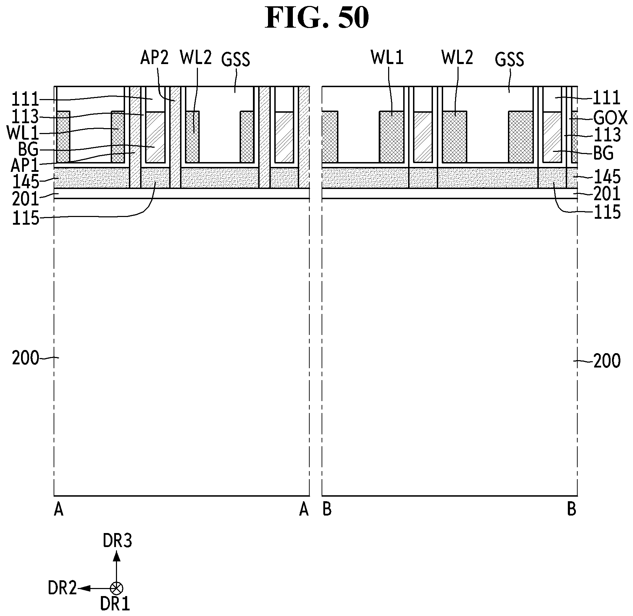

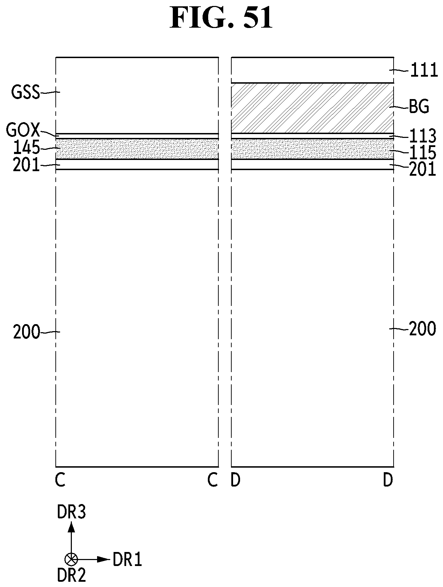

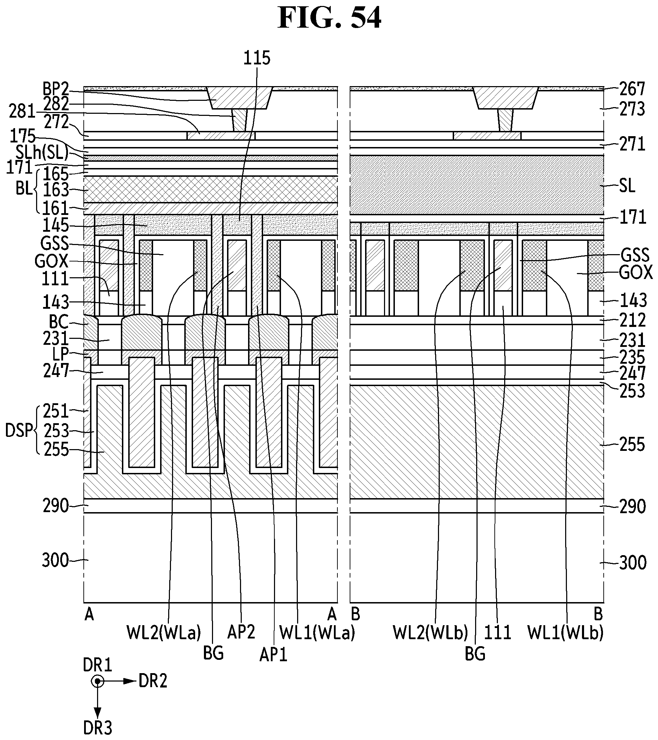

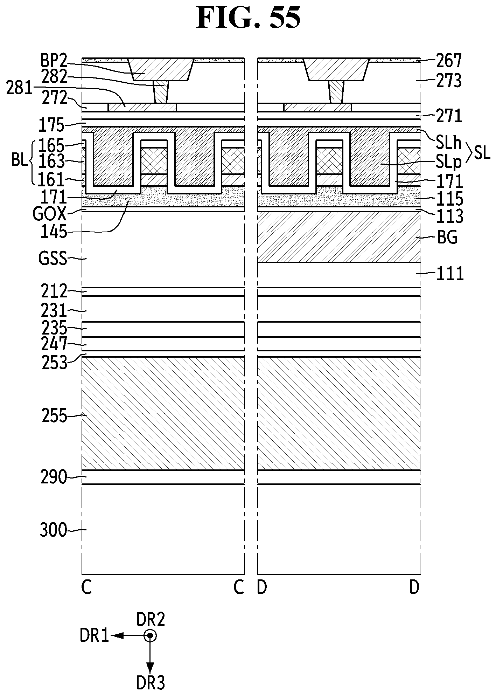

FIGS. 25 through 55 are diagrams for explaining intermediate steps of a method for manufacturing a semiconductor memory device according to some embodiments. Through the method for manufacturing a semiconductor memory device according to some embodiments, the semiconductor memory device described above with reference to any one of FIGS. 7, 8, 17, and 18 can be manufactured.

Referring to FIGS. 25 through 28, a sub-substrate structure including a first sub-substrate 200, a buried insulating layer 201, and an active layer 202 may be provided.

The buried insulating layer 201 and the active layer 202 may be provided on the first sub-substrate 200. The first sub-substrate 200, the buried insulating layer 201, and the active layer 202 may form a silicon-on-insulator (SOI) substrate. The first sub-substrate 200 may be a semiconductor substrate. For example, the first sub-substrate 200 may be a Si substrate, a Ge substrate, and/or a SiGe substrate. The first sub-substrate 200 will hereinafter be described as being a Si substrate.

The buried insulating layer 201 may be a buried oxide (BOX) formed by a separation-by-implanted oxygen (SIMOX) method or a bonding-and-layer transfer method. Alternatively, the buried insulating layer 201 may be an insulating film formed by chemical vapor deposition (CVD). The buried insulating layer 201 may include, for example, silicon oxide, silicon nitride, silicon oxynitride, and/or a low-k dielectric film.

The active layer 202 may be a monocrystalline semiconductor film. The active layer 202 may be, for example, a monocrystalline Si substrate, a Ge substrate, and/or a SiGe substrate. The active layer 202 may have a first surface and a second surface that are opposite to each other in a third direction DR3, and the second surface of the active layer 202 may be in contact with the buried insulating layer 201.

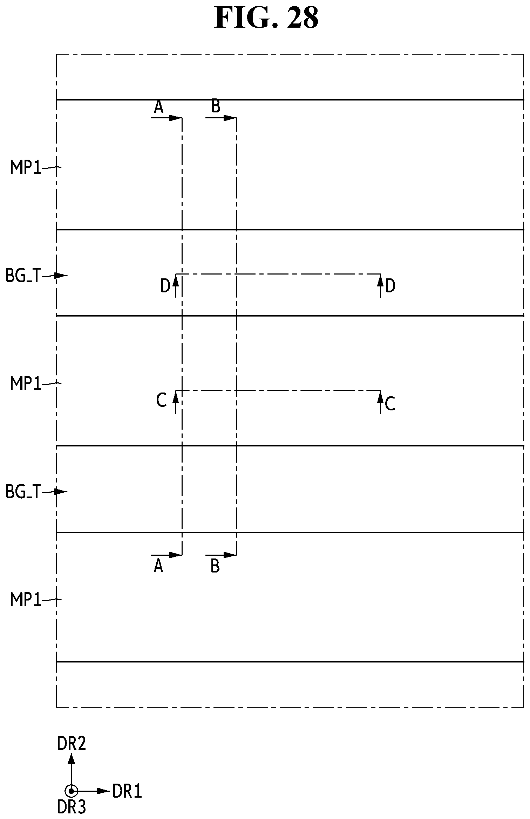

Referring to FIGS. 28 through 30, a mask pattern MP1 may be formed on the active layer 202.

The mask pattern MP1 may have linear openings extending in a first direction DR1. The mask pattern MP1 may include a first lower mask film 11 and a first upper mask film 12 that are sequentially stacked. The first upper mask film 12 may be formed of a material with etch selectivity with respect to the first lower mask film 11. For example, the first lower mask film 11 may include silicon oxide, and the first upper mask film 12 may include silicon nitride. However, the present disclosure is not limited to this example.

Thereafter, using the mask pattern MP1 as an etch mask, the active layer 202 may be anisotropically etched. As a result, back gate trenches BG_T extending in the first direction DR1 may be formed in the active layer 202. The back gate trenches BG_T may expose the buried insulating layer 201 and may be spaced apart from each other in a second direction DR2.

Alternatively, contrary to what is illustrated, at least portions of the buried insulating layer 201 may be removed during the formation of the back gate trenches BG_T.

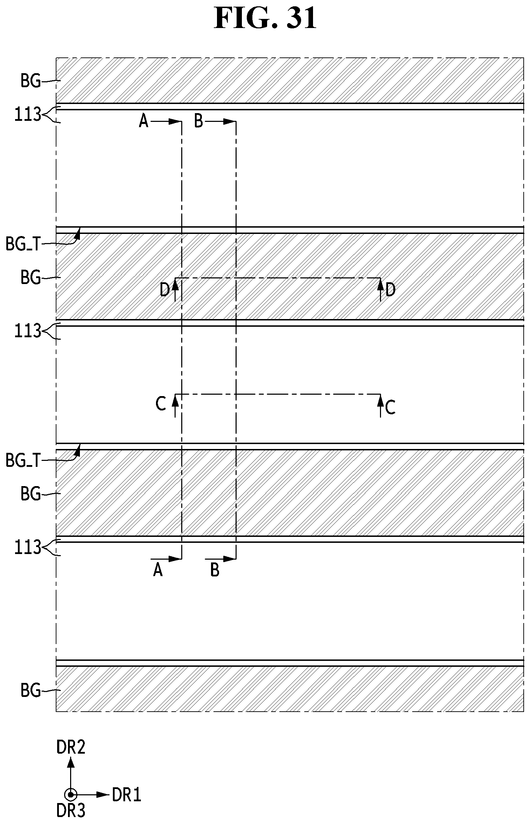

Referring to FIGS. 31 through 33, back gate shielding patterns 115, back gate insulating patterns 113, and back gate electrodes BG may be formed within the back gate trenches BG_T.

Specifically, the back gate shielding patterns 115 may be formed within the back gate trenches BG_T. The back gate shielding patterns 115 may fill portions of the back gate trenches BG_T. The back gate shielding patterns 115 may extend in the first direction DR1 along the back gate trenches BG_T. For example, the back gate shielding patterns 115 may contact portions of the active layer 202 exposed by the back gate trenches BG_T. For example, the back gate shielding patterns 115 may include an insulating material doped with phosphorus (P). Alternatively, the back gate shielding patterns 115 may include an insulating material that does not contain an n-type impurity element.

The back gate insulating patterns 113 may be formed along the sidewalls of the back gate trenches BG_T, the upper surface of the back gate shielding patterns 115, and the upper surface of the mask pattern MP1. A back gate conductive film may be formed on the back gate insulating patterns 113. The back gate conductive film may fill at least a portion of the back gate trenches BG_T. Thereafter, back gate electrodes BG that extend in the first direction DR1 may be formed by isotropically etching the back gate conductive film. The back gate electrodes BG may fill the remaining portions of the back gate trenches BG_T. During the formation of the back gate electrodes BG, a heat treatment process may be performed. During the heat treatment process, the phosphorus (P) contained in the back gate shielding patterns 115 may diffuse into the active layer 202.

Meanwhile, according to some embodiments, before the formation of the back gate insulating patterns 113, a gas phase doping (GPD) process or a plasma doping (PLAD) process may be performed. Through this, impurities may be doped into the portions of the active layer 202 exposed by the back gate trenches BG_T.

Alternatively, contrary to what is illustrated, the back gate shielding patterns 115 may not be formed before the formation of the back gate insulating pattern 113. In this case, the back gate insulating patterns 113 may extend along the sidewalls and the bottom surfaces of the back gate trenches BG_T.

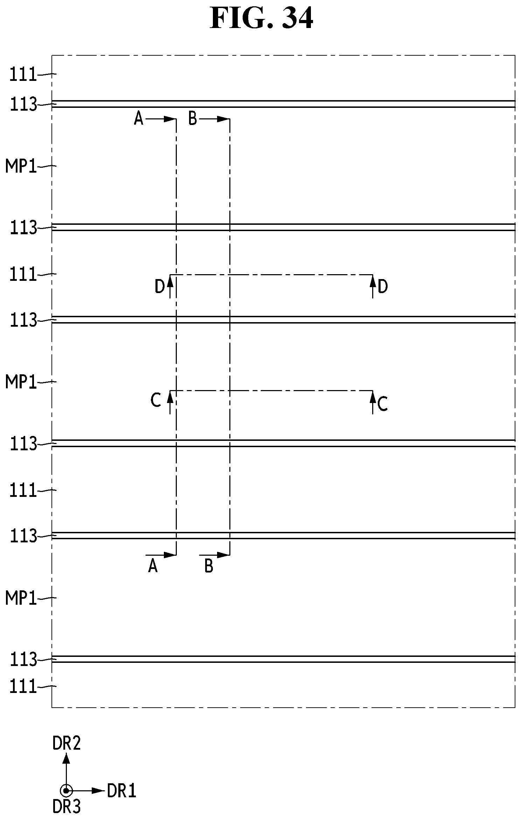

Referring to FIGS. 34 through 36, back gate separation patterns 111 may be formed on the back gate electrodes BG.

The back gate separation patterns 111 may fill the remaining portions of the back gate trenches BG_T. If the back gate separation patterns 111 and the back gate insulating patterns 113 are formed of the same material (e.g., silicon oxide), the back gate insulating patterns 113 on the upper surface of the mask pattern MP1 may be removed during the formation of the back gate separation patterns 111.

Meanwhile, before the formation of the back gate separation patterns 111, a GPD process or a PLAD process may be performed. Through this, impurities may be doped into the active layer 202 through the back gate trenches BG_T in which the back gate electrodes BG are formed.

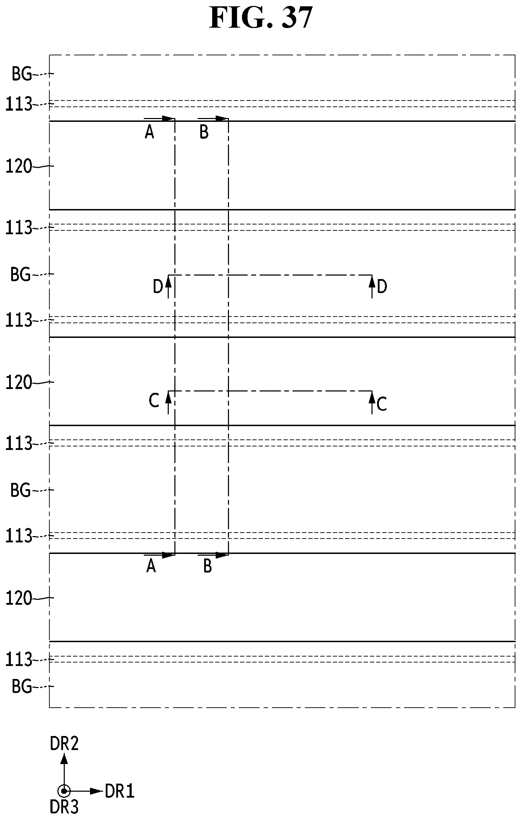

Referring to FIGS. 37 through 39, after the formation of the back gate separation patterns 111, the first upper mask film 12 may be removed.

The back gate separation patterns 111 may protrude or extend above the upper surface of the first lower mask film 11.

Thereafter, a spacer film 120 may be formed along the upper surface of the first lower mask film 11, the sidewalls of the back gate insulating patterns 113, and the upper surfaces of the back gate separation patterns 111. The spacer film 120 may be formed with a uniform thickness. The width of the active patterns of VCTs may be determined based on the deposition thickness of the spacer film 120.

The spacer film 120 may be formed of an insulating material. For example, the spacer film 120 may include silicon oxide, silicon oxynitride, silicon nitride, silicon carbide (SiC), silicon carbon nitride (SiCN), or a combination thereof.

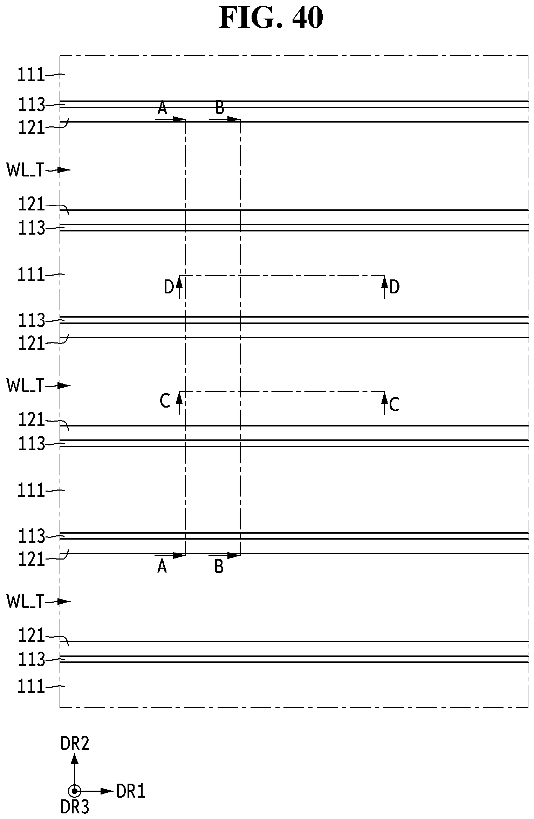

Referring to FIGS. 40 through 42, an anisotropic etching process may be performed on the spacer film 120, and pairs of spacer patterns 121 may be formed on the sidewalls of the back gate insulating patterns 113.

Using the spacer patterns 121 as an etch mask, an anisotropic etching process may be performed on the active layer 202. Through this, pairs of pre-active patterns PAP, which are separated from each other, may be formed on both sides of the back gate insulating patterns 113. As the pre-active patterns PAP are formed, the buried insulating layer 201 may be exposed.

The pre-active patterns PAP may extend in the first direction DR1 parallel to the back gate electrodes BG. During the formation of the pre-active patterns PAP, wordline trenches WL_T may be formed between adjacent pre-active patterns PAP in the second direction DR2.

Referring to FIGS. 40 through 45, a sacrificial film may be formed to fill at least a portion of the wordline trenches WL_T. A pattern mask may be formed on the sacrificial film. The pattern mask may have a linear shape extending in the second direction DR2. In another example, the pattern mask may have a linear shape extending obliquely with respect to the first and second directions DR1 and DR2. Using the pattern mask as an etch mask, the sacrificial film may be etched to form sacrificial openings in the sacrificial film.

By etching the pre-active patterns PAP exposed by the sacrificial openings, first active patterns AP1 and second active patterns AP2 may be formed on both sides of the back gate electrodes BG. On the first sidewalls of the back gate electrodes BG, the first active patterns AP1 may be formed spaced apart from each other in the first direction DR1. On the second sidewalls of the back gate electrodes BG, the second active patterns AP2 may be formed to be spaced apart from each other in the first direction DR1. As the first active patterns AP1 and the second active patterns AP2 are formed, the sacrificial openings may expose portions of the back gate insulating patterns 113.

Thereafter, the sacrificial film, the pattern mask, and the spacer patterns 121 may be removed. The first lower mask film 11 may remain on the first active patterns AP1 and the second active patterns AP2. The buried insulating layer 201 may be exposed.

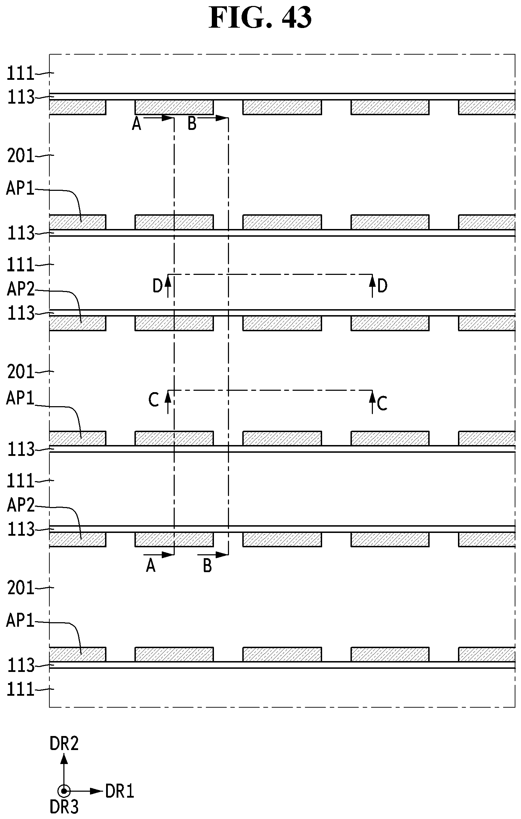

Referring to FIGS. 43 through 47, gate shielding patterns 145 may be formed within the wordline trenches WL_T.

The gate shielding patterns 145 may fill portions of the wordline trenches WL_T. The gate shielding patterns 145 may be formed on the buried insulating layer 201. The gate shielding patterns 145 may extend in the first direction DR1 along the wordline trenches WL_T.

For example, the gate shielding patterns 145 may contact the first active patterns AP1 and the second active patterns AP2. In one example, the gate shielding patterns 145 may include an insulating material doped with phosphorus (P). In another example, the gate shielding patterns 145 may include an insulating material that does not contain an n-type impurity element.

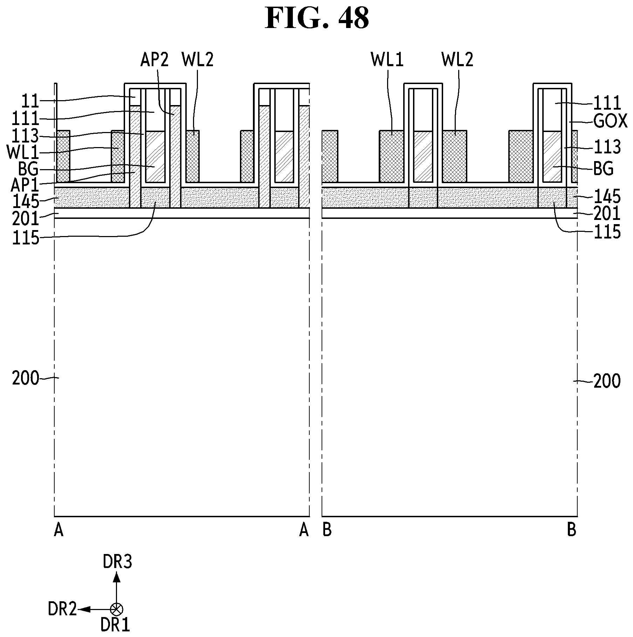

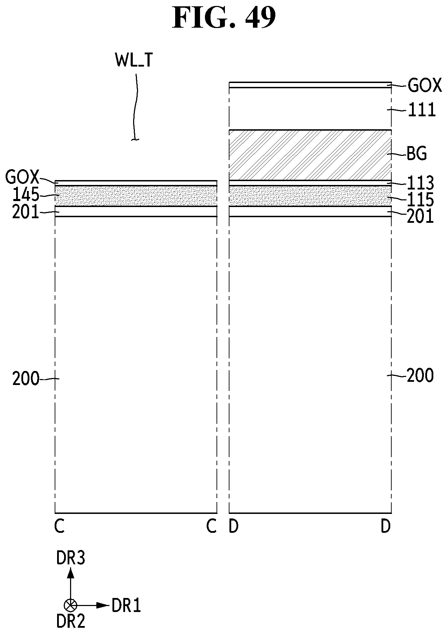

Referring to FIGS. 48 and 49, gate insulating patterns GOX may be formed along the sidewalls of the first active patterns AP1, the sidewalls of the second active patterns AP2, and the upper surfaces of the back gate separation patterns 111.

The gate insulating patterns GOX may be formed along the upper surfaces of the gate shielding patterns 145. The gate insulating patterns GOX may be formed using at least one of physical vapor deposition (PVD), thermal CVD, low-pressure chemical vapor deposition (LP-CVD), plasma-enhanced chemical vapor deposition (PE-CVD), or atomic layer deposition (ALD), but the present disclosure is not limited thereto.

Alternatively, contrary to what is illustrated, the gate shielding patterns 145 may not be formed before the formation of the gate insulating patterns GOX.

Thereafter, first wordlines WL1 and second wordlines WL2 may be formed on the gate insulating patterns GOX.

In one example, a first pre-wordline film may be formed on the gate insulating patterns GOX. The first pre-wordline film may fill at least a portion of the wordline trenches WL_T. The first wordlines WL1 and the second wordlines WL2 may be formed by patterning the first pre-wordline film. In another example, a second pre-wordline film may be formed along the profile of the gate insulating patterns GOX. The second pre-wordline film may take the form of a liner. The first wordlines WL1 and the second wordlines WL2 may be formed by anisotropically etching the second pre-wordline film.

During the formation of the first wordlines WL1 and the second wordlines WL2, a heat treatment process may be performed. During the heat treatment process, the phosphorus (P) contained in the gate shielding patterns 145 may diffuse into the first active patterns AP1 and the second active patterns AP2.

As phosphorus (P) diffuses from the gate shielding patterns 145 and/or the back gate shielding patterns 115, first impurity doping regions ("AP_SDR" in FIGS. 4, 8, and 11) may be formed.

Referring to FIGS. 48 through 51, gate separation patterns GSS may be formed on the first wordlines WL1 and the second wordlines WL2.

For example, the upper surfaces of the gate separation patterns GSS may be on the same plane as the upper surfaces of the back gate separation patterns 111.

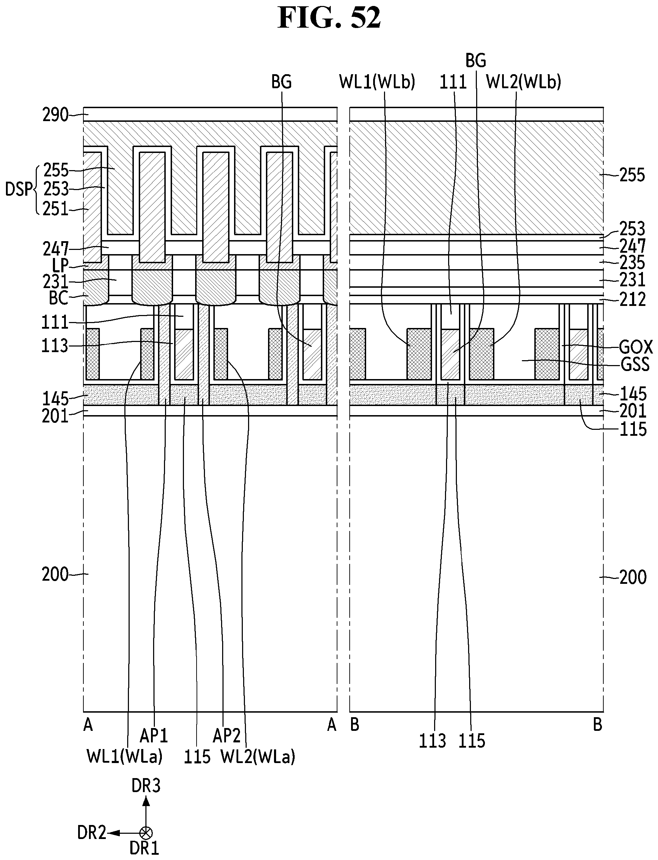

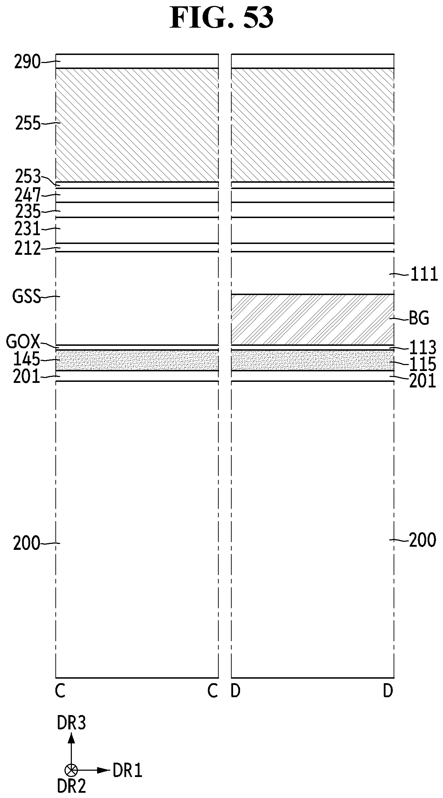

Referring to FIGS. 52 and 53, contact holes exposing the first active patterns AP1 and the second active patterns AP2 may be formed within the contact etch stop film 212 and the contact interlayer insulating film 231.

Contact patterns BC may be formed within the contact holes. The contact patterns BC may be formed on the first active patterns AP1 and the second active patterns AP2. The contact patterns BC may be connected to the first active patterns AP1 and the second active patterns AP2. Data storage patterns DSP may be formed on the contact patterns BC.

Thereafter, a cell upper insulating film 290 may be formed on the data storage patterns DSP.

If a high-temperature heat treatment process is performed after the formation of the data storage patterns DSP, thermal stress may occur in the data storage patterns DSP. Due to the thermal stress generated in the data storage patterns DSP, cracks or other defects may occur within the data storage patterns DSP. As a result, the performance and reliability of the semiconductor memory device may be degraded.

During the formation of the back gate electrodes BG and/or the wordlines (WL1 and WL2), first impurity doping regions ("AP_SDR" in FIGS. 4, 8, and 11) may be formed. Since junctions are formed between the active patterns (AP1 and AP2) and the bitlines BL by the first impurity doping regions AP_SDR, the resistance between the active patterns (AP1 and AP2) and the bitlines BL may be reduced. As the first impurity doping regions AP_SDR are formed before the formation of the data storage patterns DSP, the high-temperature heat treatment process may not be performed after the formation of the data storage patterns DSP. In other words, thermal stress that may be caused by the high-temperature heat treatment process may not be generated in the data storage patterns DSP. Accordingly, the performance and reliability of the semiconductor memory device can be improved.

Referring to FIGS. 52 through 55, the first sub-substrate 200, in which the back gate electrodes BG, wordlines WL1, WL2, active patterns AP1, AP2, and data storage patterns DSP are formed, may be bonded to a second sub-substrate 300.

The back gate electrodes BG, the wordlines (WL1 and WL2), the active patterns (AP1 and AP2), and the data storage patterns DSP may be disposed between the first and second sub-substrates 200 and 300.

Although not illustrated, the first and second sub-substrates 200 and 300 may be bonded using a bonding adhesive film.

In one example, the second sub-substrate 300 may be a semiconductor substrate. In another example, the second sub-substrate 300 may be an insulating substrate including an insulating material.

Thereafter, after bonding the first and second sub-substrates 200 and 300, a backside lapping process may be performed to remove the first sub-substrate 200.

Removing the first sub-substrate 200 may involve sequentially performing a grinding process and a wet etching process to expose the buried insulating layer 201.

Thereafter, the first active patterns AP1 and the second active patterns AP2 may be exposed by removing the buried insulating layer 201. As the buried insulating layer 201 is exposed, the back gate shielding patterns 115 and the gate shielding patterns 145 may also be exposed.

Thereafter, bitlines BL extending in the second direction DR2 may be formed on the first active patterns AP1 and the second active patterns AP2. Shielding conductive patterns SL may be formed on the bitlines BL. A shielding insulating capping film 175 may be formed on the shielding conductive patterns SL.

Thereafter, a first cell lower insulating film 271 may be formed on the shielding insulating capping film 175. A second cell lower insulating film 272 may be formed on the first cell lower insulating film 271. Cell connection wires 281 may be formed within the second cell lower insulating film 272. A third cell lower insulating film 273 may be formed on the second cell lower insulating film 272. Upper pad plugs 282 and upper bonding pads BP2 may be formed within the third cell lower insulating film 273.

Thereafter, referring to FIGS. 7, 8, 17, and 18, a substrate 100, in which a peri-gate structure PG, a first peri-connection structure (242a and 242b), a second peri-connection structure (243a and 243b), lower bonding pads BP1, and lower pad plugs 244 are formed, may be bonded to the second sub-substrate 300.

The second sub-substrate 300 and the substrate 100 may be bonded using a bonding adhesive film 267. Alternatively, contrary to what is illustrated, the second sub-substrate 300 and the substrate 100 may be bonded without a bonding adhesive film 267.

Thereafter, the second sub-substrate 300 may be removed.

In concluding the detailed description, those skilled in the art will appreciate that many variations and modifications may be made to the embodiments without substantially departing from the principles of the present disclosure. Therefore, the disclosed embodiments of the disclosure are used in a generic and descriptive sense only and not for purposes of limitation.

Embodiments are set out in the following clauses:
Clause 1. A semiconductor memory device comprising:
   a bitline that extends in a first direction on a substrate;
   an active pattern disposed on the bitline, the active pattern comprising a first sidewall and a second sidewall opposite to each other in the first direction, the active pattern comprising a first surface and a second surface opposite to each other in a vertical direction that is perpendicular to the substrate, wherein the first surface of the active pattern is electrically connected to the bitline;
   a wordline that is on the first sidewall of the active pattern and extends in a second direction;
   a back gate electrode that is on the second sidewall of the active pattern and extends in the second direction;
   a first gate shielding pattern between the wordline and the bitline;
   a second gate shielding pattern between the back gate electrode and the bitline; and
   a data storage pattern that is on the active pattern and electrically connected to the second surface of the active pattern,
   wherein at least one of the first gate shielding pattern and the second gate shielding pattern comprises phosphorus silicate glass (PSG).
Clause 2. The semiconductor memory device of clause 1, wherein each of the first gate shielding pattern and the second gate shielding pattern comprises PSG.
Clause 3. The semiconductor memory device of clause 1, wherein:
   the first gate shielding pattern comprises PSG, and
   the second gate shielding pattern does not comprise PSG.
Clause 4. The semiconductor memory device of cause 1, wherein:
   the second gate shielding pattern comprises PSG, and
   the first gate shielding pattern does not comprise PSG.
Clause 5. The semiconductor memory device of any of clauses 1 to 4, further comprising:
   a connection semiconductor pattern that contacts the first surface of the active pattern and is between the active pattern and the bitline.
Clause 6. The semiconductor memory device of any of clauses 1 to 5, further comprising a shielding conductive pattern on the substrate, wherein:
   the shielding conductive pattern comprises a shielding conductive plate and a plurality of shielding conductive line patterns that extend from the shielding conductive plate,
   each of the plurality of shielding conductive line patterns extend in the first direction, and
   the bitline is between first and second shielding conductive line patterns of the plurality of shielding conductive line patterns in the second direction.
Clause 7. A semiconductor memory device comprising:
   a peri-gate structure on a substrate;
   a first bonding pad on the peri-gate structure;
   a second bonding pad that is on and contacts the first bonding pad;
   a bitline that is on the second bonding pad and extends in a first direction;
   a shielding conductive pattern that is on the second bonding pad, is adjacent to the bitline, extends in the first direction, and comprises a plurality of shielding conductive line patterns;
   a first wordline that is on the bitline and the shielding conductive pattern and extends in a second direction;
   a second wordline that is on the bitline and the shielding conductive pattern, extends in the second direction, and is spaced apart from the first wordline in the first direction;
   a back gate electrode that is between the first wordline and the second wordline and extends in the second direction;
   a first active pattern that is on the bitline and is between the first wordline and the back gate electrode;
   a second active pattern that is on the bitline and is between the second wordline and the back gate electrode;
   a first gate shielding pattern that is between the first wordline and the bitline, is between the second wordline and the bitline, and comprises an insulating material that is doped with phosphorus (P); and
   a data storage pattern electrically connected to the first active pattern and the second active pattern.
Clause 8. The semiconductor memory device of clause 7, further comprising:
   a second gate shielding pattern that is between the back gate electrode and the bitline and comprises an insulating material that is doped with P.
Clause 9. The semiconductor memory device of clause 7 or clause 8, wherein the first gate shielding pattern comprises phosphorus silicate glass (PSG).
Clause 10. The semiconductor memory device of any of clauses 7 to 9, wherein:
   the shielding conductive pattern further comprises a shielding conductive plate,
   the shielding conductive line patterns extend from the shielding conductive plate in a third direction that is perpendicular to the first direction and the second direction, and
   the bitline is on the shielding conductive plate.

## Claims

1. A semiconductor memory device comprising:
a bitline (BL) that extends in a second direction (DR2) on a substrate (100);
a first active pattern (AP1) and a second active pattern (AP2) that are on the bitline (BL) and spaced apart from each other in the second direction (DR2);
at least one conductive gate line (WL1, WL2) that is between the first active pattern (AP1) and the second active pattern (AP2) and extends in a first direction (DR1);
a gate shielding pattern (145) that is between the at least one conductive gate line (WL1, WL2) and the bitline (BL) and comprises an insulating material that is doped with phosphorus (P); and
a data storage pattern (DSP) that is on and electrically connected to the first active pattern (AP1) and the second active pattern (AP2).

2. The semiconductor memory device of claim 1, wherein:
the at least one conductive gate line (WL1, WL2) comprises a first wordline (WL1) and a second wordline (WL2), and
the first and second wordlines (WL1, WL2) are spaced apart from each other in the second direction (DR2).

3. The semiconductor memory device of claim 2, wherein:
the first wordline (WL1) is closer than the second wordline (WL2) to the first active pattern (AP1),
the first active pattern (AP1) comprises a first sidewall (SS1) and a second sidewall (SS2) that are opposite to each other in the second direction (DR2), and
the conductive gate line (WL1, WL2) is on the first sidewall (SS1) of the first active pattern (AP1) and is not disposed on the second sidewall (SS2) of the first active pattern (AP1).

4. The semiconductor memory device of any preceding claim, wherein the at least one conductive gate line (WL1, WL2) comprises a first conductive gate line (BG) between the first active pattern (AP1) and the second active pattern (AP2).

5. The semiconductor memory device of any preceding claim, wherein the gate shielding pattern (145) comprises phosphorus silicate glass (PSG).

6. The semiconductor memory device of any preceding claim, wherein:
the first active pattern (AP1) and the second active pattern (AP2) comprise impurity-doped regions (AP_SDR) in contact with the gate shielding pattern (145), and
the impurity-doped regions (AP_SDR) comprise P.

7. The semiconductor memory device of any preceding claim, further comprising:
a connection semiconductor pattern (AP_EP) that contacts the first active pattern (AP1) and is between the first active pattern (AP1) and the bitline (BL).

8. The semiconductor memory device of any preceding claim, further comprising a gate insulating pattern (GOX) between the first active pattern (AP1) and the conductive gate line (WL1, WL2), wherein:
the gate shielding pattern (145) comprises an upper surface (145_S2) and a bottom surface (145_S1) that are opposite to each other in a third direction (DR3) that is perpendicular to the first direction (DR1) and the second direction (DR2),
the bottom surface (145_S1) of the gate shielding pattern (145) faces the bitline (BL), and
the gate insulating pattern (GOX) extends along the upper surface (145_S2) of the gate shielding pattern (145).

9. The semiconductor memory device of any preceding claim, further comprising a shielding conductive pattern (SL) disposed on the substrate (100), wherein:
the shielding conductive pattern (SL) comprises a shielding conductive plate (SLh) and a plurality of shielding conductive line patterns (SLp) that extend from the shielding conductive plate (SLh),
each of the plurality of shielding conductive line patterns (SLp) extend in the second direction (DR2),
the bitline (BL) is between first and second shielding conductive line patterns (SLp) of the plurality of shielding conductive line patterns (SLp), and
the first shielding conductive line pattern (SLp) and the second shielding conductive line pattern (SLp) are adjacent in the first direction (DR1).

10. The semiconductor memory device of any preceding claim, further comprising a shielding conductive pattern (SL) disposed adjacent to the bitline (BL) in the first direction (DR1) and extending in the second direction (DR2), wherein:
the bitline (BL) comprises an upper surface (BL_US) and a bottom surface (BL_BS) that are opposite to each other in a third direction (DR3) that is perpendicular to the first direction (DR1) and the second direction (DR2),
the upper surface (BL_US) of the bitline (BL) faces the first active pattern (AP1) and the second active pattern (AP2), and
the shielding conductive pattern (SL) is not disposed on the bottom surface (BL_BS) of the bitline (BL).

11. A semiconductor memory device comprising:
a bitline (BL) that extends in a second direction (DR2) on a substrate (100);
an active pattern (AP1) disposed on the bitline (BL), the active pattern (AP1) comprising a first sidewall (SS1) and a second sidewall (SS2) opposite to each other in the second direction (DR2), the active pattern (AP1) comprising a first surface (S1) and a second surface (S2) opposite to each other in a vertical direction (DR3) that is perpendicular to the substrate (100), wherein the first surface (S1) of the active pattern (AP1) is electrically connected to the bitline (BL);
a wordline (WL1) that is on the first sidewall (SS1) of the active pattern (AP1) and extends in a first direction (DR1);
a back gate electrode (BG) that is on the second sidewall (SS2) of the active pattern (AP1) and extends in the first direction (DR1);
a first gate shielding pattern (145) between the wordline (WL1) and the bitline (BL);
a second gate shielding pattern (115) between the back gate electrode and the bitline (BL); and
a data storage pattern (DSP) that is on the active pattern (AP1) and electrically connected to the second surface (S2) of the active pattern (AP1),
wherein at least one of the first gate shielding pattern (145) and the second gate shielding pattern (115) comprises phosphorus silicate glass (PSG).

12. The semiconductor memory device of claim 11, wherein each of the first gate shielding pattern (145) and the second gate shielding pattern (115) comprises PSG.

13. The semiconductor memory device of claim 11, wherein:
the first gate shielding pattern (145) comprises PSG, and
the second gate shielding pattern (115) does not comprise PSG.

14. A semiconductor memory device comprising:
a peri-gate structure (PG) on a substrate (100);
a first bonding pad (BP1) on the peri-gate structure (PG);
a second bonding pad (BP2) that is on and contacts the first bonding pad (BP1);
a bitline (BL) that is on the second bonding pad (BP2) and extends in a second direction (DR2);
a shielding conductive pattern (SL) that is on the second bonding pad (BP2), is adjacent to the bitline (BL), extends in the second direction (DR2), and comprises a plurality of shielding conductive line patterns (SLp);
a first wordline (WL1) that is on the bitline (BL) and the shielding conductive pattern (SL) and extends in a first direction (DR1);
a second wordline (WL2) that is on the bitline (BL) and the shielding conductive pattern (SL), extends in the first direction (DR1), and is spaced apart from the first wordline (WL1) in the second direction (DR2);
a back gate electrode (BG) that is between the first wordline (WL1) and the second wordline (WL2) and extends in the first direction (DR1);
a first active pattern (AP1) that is on the bitline (BL) and is between the first wordline (WL1) and the back gate electrode (BG);
a second active pattern (AP2) that is on the bitline (BL) and is between the second wordline (WL2) and the back gate electrode (BG);
a first gate shielding pattern (145) that is between the first wordline (WL1) and the bitline (BL), is between the second wordline (WL2) and the bitline (BL), and comprises an insulating material that is doped with phosphorus (P); and
a data storage pattern (DSP) electrically connected to the first active pattern (AP1) and the second active pattern (AP2).

15. The semiconductor memory device of claim 14, further comprising:
a second gate shielding pattern (115) that is between the back gate electrode (BG) and the bitline (BL) and comprises an insulating material that is doped with P.
